(19) Europäisches Patentamt / European Patent Office / Office européen des brevets

(11) **EP 2 720 275 A1**

(12) **EUROPEAN PATENT APPLICATION**
published in accordance with Art. 153(4) EPC

(43) Date of publication:
**16.04.2014 Bulletin 2014/16**

(51) Int Cl.:
*H01L 31/04* (2014.01)     *H01S 5/343* (2006.01)
*B82Y 20/00* (2011.01)

(21) Application number: **12799996.9**

(22) Date of filing: **13.06.2012**

(86) International application number:
**PCT/JP2012/065172**

(87) International publication number:
**WO 2012/173162 (20.12.2012 Gazette 2012/51)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.06.2011 JP 2011131515**

(71) Applicant: **Tohoku University**
**Sendai-shi, Miyagi 980-8577 (JP)**

(72) Inventor: **SAMUKAWA Seiji**
**Sendai-shi**
**Miyagi 980-8577 (JP)**

(74) Representative: **Isarpatent**
**Patent- und Rechtsanwälte**
**Friedrichstrasse 31**
**80801 München (DE)**

(54) **QUANTUM NANODOTS, TWO-DIMENSIONAL QUANTUM NANODOT ARRAY AND
SEMICONDUCTOR DEVICE USING SAME AND MANUFACTURING METHOD THEREFOR**

(57)     Provided are a quantum nanodot, a two-dimensional quantum nanodot array as well as a semiconductor device using the same and a production method therefor. A quantum nanodot 3 is formed of a semiconductor and has an outer diameter in two-dimensional directions which is not more than twice a bore radius of an exciton in the semiconductor. A two-dimensional quantum nanodot array 1 has such a structure that the quantum nanodots 3 are two-dimensionally and uniformly arranged with a spacing between the quantum nanodots 3 being 1 nm or more. Further, the two-dimensional nanodot array 1 may further include an intermediate layer 6 which is made of a semiconductor or an insulator and is filled between the quantum nanodot arrays 10. Since the quantum nanodots have high orientation and high density, a high quantum confinement effect is attained. Therefore, the quantum nanodot 3 made of Si produces direct transition type luminescence. Also, it is possible to control an optical property and a transport property of the two-dimensional quantum nanodot array 10 including the intermediate layer 6.

FIG.1

**Description**

Technical Field

The present invention relates to quantum nanodots and a two-dimensional quantum nanodot array as well as a semiconductor device using the same, and a production method therefor. More specifically, the present invention relates to quantum nanodots of about 10 nm or less having high uniformity, a high density two-dimensional quantum nanodot array in which the quantum nanodots are two-dimensionally arranged, a two-dimensional quantum nanodot array which comprises an intermediate layer comprising a semiconductor or an insulator and filled between the quantum nanodots of the two-dimensional quantum nanodot array and is capable of controlling a light absorption property and a carrier transport property, a semiconductor device using the array, and a method for producing the array.

Background Art

For the smallest processing dimension in microfabrication of a semiconductor integrated circuit, 22-nm exposure has been put into practice. Further, an electron beam or a focusing ion beam (FIB) is used for processing of the size of about 10 nm or so. It has been regarded that it is difficult to perform processing of the size of 10 nm or less by using the electron beam or FIB. The above-described processing method is a method of scraping off from the top, which is a so-called top-down technology.

A material corresponding to a bore radius of an exciton in a semiconductor, i.e. a nanomaterial, behaves as a quantum dot due to three-dimensional quantum confinement of a carrier and exhibits a quantum size effect. The quantum size effect enables to control an energy (Eg) of a bandgap by changing the size of the quantum dot. A miniband is generated in a plurality of quantum dots. The miniband is closely associated with a confined energy level. In the case of contemplating an application of the quantum dots, the quantum dots processed into the order of nanometers has a great potential as a novel absorption layer for a solar cell comprising tandem type Si (see Non-Patent Literatures 1 to 4).

A layer disposed between a plurality of quantum dots is called an intermediate layer. As a material for the intermediate layer, SiC is promising. The intermediate layer comprising SiC and the solar cell comprising the Si quantum dots readily form the miniband. The inventors fabricated a quantum dot of about 12 nm by preparing a quantum dot comprising Si and GaAs using ferritin which is a protein containing a metal (see Non-Patent Literatures 5 and 6).

Citation List

Patent Literature

Patent Literature 1: JP 2009-290026 A Non-Patent Literature
Non-Patent Literature 1: G. Conibeer, Thin Solid Films 511, (2009), P. 654
Non-Patent Literature 2: Y. Okada, R. Oshima and A. Takata, J. Appl. Phys., 106, (2009), P. 024306
Non-Patent Literature 3: R. B. Laghumavarapu, M. EL-Emawy, N. Nuntawong, A. Moscho, L. F. Lester, and D. L. Huffaker, Appl. Phys. Lett., 91, (2007), p. 243115
Non-Patent Literature 4: R. P. Raffaelle, S. L. Castro, A. F. Hepp, and S. G. Bailey, Prog., Photovolt., Res. Appl., 10, (2002), p. 443
Non-Patent Literature 5: C. H. Huang, X. Y. Wang, M. Igarashi, A. Murayama, Y. Okada, I. Yamashita and S. Samukawa, Nanotechnology, 22, (2011), P. 105301
Non-Patent Literature 6: M. Igarashi et al., "Direct fabrication of uniform and high density of sub-10 nm etching mask using ferritin molecules on Si and GaAs surface for actual quantum-dot superlattice.", Appl. Phys. Express., 4, (2011), P. 015202
Non-Patent Literature 7: "Superlattice Heterostructure Device", supervised by Reona Ezaki, edited by Hiroyuki Sakaki, published by Kogyo Chosakai Publishing Co., Ltd., published on September 10, 1988, p. 72
Non-Patent Literature 8: W. Xiaoming, L. V. Dao, P. Hannaford, J. Phys. D: Appl. Phys. 40 (2007), p. 3573
Non-Patent Literature 9: W. de Boer, H. Zhang, and T. Gregorkiewicz, Mater. Sci. Eng. B190 (2009), P. 159
Non-Patent Literature 10: K. Kusova, O. Cibulka, K. Dohnalova, I. Pelant, J. Valenta, A. Fucikova, K. Zidek, J. Lang, J. Englich, P. Matejka, P. Stepanek, and S. Bakardjieva, ACS Nano 4 (2010), P. 4495
Non-Patent Literature 11: T. Yoshikawa et al., "Dry etching and consequent burring regrowth of nanosize quantum wells stripes using an in situ ultrahigh vacuum multichamber system", J. Vac. Sci. Technol. B 16, (1998), pp. 1-8

## Summary of Invention

### Technical Problem

However, with the conventional technology such as the plasma processing involving lithography and sputtering technology involving annealing, it is difficult to fabricate a quantum dot having the size of nanometer order, particularly the size smaller than 10 nm. Further, though a flexible process is required for a semiconductor device to which different quantum dot materials such as Si and a compound semiconductor and quantum nanodots are applied, such a process has not been realized yet.

In view of the above-described problems, an object of the present invention is to provide a quantum nanodot having a dimension of about 10 nm or less of which realization has been difficult with the conventional methods, a two-dimensional quantum nanodot array, a semiconductor device using the array, and a method for producing the array.

### Solution to Problem

The inventors formed Si quantum nanodots by using a monomolecular layer of a protein containing a metal having a diameter of a several nanometers as dimensions in two-dimensional directions and by preventing generation of a defect in a semiconductor or the like serving as quantum nanodots and controlled a light absorption property and luminescence by controlling a quantum confinement effect of a diameter, a thickness, and the like of the quantum nanodot. Thus, the inventors observed first in the world that it is possible to control direct transition type luminescence from the Si quantum nanodots and a luminescence wavelength to accomplish the present invention.

In order to attain a first object, a quantum nanodot of the present invention comprises a semiconductor and has an outer diameter in two-dimensional directions which is not more than twice a bore radius of an exciton in the semiconductor.

In the above-described structure, the semiconductor may preferably be Si and has the outer diameter in two-dimensional directions of 10 nm or less.

The quantum nanodot of the present invention is capable of producing luminescence. A half value width of a 665 nm luminescence peak of the quantum nanodot of the present invention may preferably be about 0.2 eV in photoluminescence properties excited at 400 nm.

A quantum confinement effect of the quantum nanodot may preferably be controlled by changing a thickness and a dimension in two-dimensional directions thereof.

A surface density of the quantum nanodots may preferably be from $1\times10^{12}/cm^2$ to $5\times10^{12}/cm^2$.

In order to attain a second object, in a two-dimensional quantum nanodot array of the present invention, a quantum nanodot of the present invention comprises a semiconductor and has an outer diameter in two-dimensional directions which is not more than twice a bore radius of an exciton in the semiconductor, a multiple of the quantum nanodots are two-dimensionally and uniformly arranged with a spacing between the adjacent quantum nanodots being 1 to 10 nm.

In the above structure, the semiconductor may preferably be Si and has the outer diameter in two-dimensional directions of 10 nm or less.

The quantum nanodot may preferably produce luminescence. A half value width of a 665 nm luminescence peak of the quantum nanodot may preferably be about 0.2 eV in photoluminescence properties excited at 400 nm.

A surface density of the quantum nanodots may preferably be from $1\times10^{12}/cm^2$ to $5\times10^{12}/cm^2$.

Further, an intermediate layer comprising a semiconductor or an insulator is filled between the two-dimensional quantum nanodot arrays.

A transport property of the two-dimensional quantum nanodot array may preferably be controlled by a distance between the adjacent quantum nanodots.

An optical absorption property and a carrier transport property of the two-dimensional quantum nanodot array may preferably be controlled by a distance between the adjacent quantum nanodots.

The intermediate later may preferably comprise a semiconductor or an insulator having a bandgap which is larger than that of the quantum nanodot. The intermediate layer may preferably be any one of $SiO_2$, $Si_3O_4$, and SiC.

The transport property of the two-dimensional quantum nanodot array is preferably controlled by the intermediate layer and the distance between the adjacent quantum nanodots.

The optical absorption property of the two-dimensional quantum nanodot array can be controlled by the intermediate layer and the distance between the adjacent quantum nanodots.

In order to attain a third object, a semiconductor device of the present invention comprises any one of the two-dimensional quantum nanodot arrays described above.

In the above structure, the semiconductor device may preferably be a solar cell. The solar cell may preferably comprise the two-dimensional quantum nanodot array at least and two or more layers having different bandgap energies.

Also, a plurality of the two-dimensional quantum nanodot arrays having an identical bandgap may be laminated and used.

The semiconductor device may preferably be a semiconductor laser, and an active layer of the semiconductor layer comprises the two-dimensional quantum nanodot array.

In order to attain a fourth object, a two-dimensional quantum nanodot array production method of the present invention comprises: forming a protein containing a metal having an outer diameter in two-dimensional directions which is not more than twice a bore radius of an exciton in a semiconductor in two-dimensional directions on a semiconductor layer which is to be formed into quantum nanodots; etching the protein; forming the quantum nanodots which comprise the semiconductor layer and are two-dimensionally arranged by etching the semiconductor layer by using a compound which contains the metal exposed by the etching as a mask; and etching the metal-containing compound.

In the above structure, the metal-containing protein may preferably be Listeria ferritin.

The semiconductor layer may preferably be deposited by using neutral particles. The semiconductor layer may preferably be etched by using neutral particles.

A layer to be used as the intermediate layer may preferably be deposited on the two-dimensional quantum nanodots formed after the etching of the metal-containing compound.

Advantageous Effects of Invention

Since the quantum nanodot of the present invention has dimensions in two-dimensional directions which are not more than twice a bore radius of an exciton in a semiconductor, high orientation, and a high density, the quantum nanodot attains a high quantum confinement effect. Therefore, the quantum nanodot comprising Si produces direct transition type luminescence.

Since the two-dimensional quantum nanodot array of the present invention has the quantum nanodot with the dimensions in two-dimensional directions which are not more than twice a bore radius of an exciton in a semiconductor, high orientation, and a high density, the two-dimensional quantum nanodot array attains good quantum confinement effect, light absorption property, and transport property.

The semiconductor device using the quantum nanodot and the two-dimensional quantum nanodot array of the present invention attains good efficiency due to the quantum confinement effect.

According to a two-dimensional quantum nanodot array production method of the present invention, it is possible to produce the highly oriented and high-density two-dimensional quantum nanodot array of the quantum nanodot which is smaller than about 10 nm by using the metal-containing protein as a template.

Brief Description of Drawings

Figs. 1(a) to (b) are diagrams showing a structure of a two-dimensionally arranged quantum nanodot array according to the present invention, wherein Fig. 1(a) is a plan view, and Fig. 1(b) is a sectional view taken along a line I-I of (a);

Fig. 2 is an enlarged sectional view of the quantum nanodot of Fig. 1;

Fig. 3 is a diagram showing dimensions of the quantum nanodot;

Fig. 4 shows energy band structures illustrating direct transition and indirect transition;

Figs. 5(a) to (b) are diagrams showing another structure of the two-dimensionally arranged quantum nanodot array, in which Fig. 5(a) is a plan view, and Fig. 5(b) is a sectional view taken along a line II-II of Fig. 5(a);

Fig. 6 is a diagram showing a band of the two-dimensionally arranged quantum nanodot array of Fig. 5;

Figs. 7 (a) to 7(c) are specific examples of the band diagrams using Si for the quantum nanodots and various intermediate layers, in which the intermediate layers of Figs. 7(a), 7(b), and 7(c) are $SiO_2$, $Si_3O_4$, and SiC, respectively;

Fig. 8(a) is a cross-section of a two-dimensional quantum nanodot array structure having an intermediate layer, and Fig. 8(b) schematically shows an IV property illustrating a transport property of the two-dimensional quantum nanodot array structure;

Fig. 9 is a diagram illustrating light absorption properties of two-dimensional quantum nanodot array structures having an intermediate layer;

Fig. 10 is a perspective view showing a cross-sectional structure of a solar cell using the two-dimensional quantum nanodot array having intermediate layer of the present invention;

Fig. 11 is a sectional view showing a structure of a semiconductor laser diode using the two-dimensional quantum nanodot array having intermediate layer of the present invention;

Figs. 12(a) to (h) are diagrams showing a two-dimensional quantum nanodot array production method in sequence;

Fig. 13 is a diagram schematically showing a structure of a deposition apparatus using neutral particles;

Figs. 14(a) to (b) are diagrams showing scanning electron microscopic images of a two-dimensional quantum nanodot array produced by the production method of Fig. 12 and having the intermediate layer, in which Fig. 14(a) shows a surface thereof and Fig. 14(b) shows a cross-section thereof;

Fig. 15 is a diagram showing a scanning electron microscopic image of a surface of a conventional two-dimensional quantum nanodot array produced by using ferritin;

Figs. 16(a) to (c) are diagrams showing measurement results obtained by time-resolved photoluminescence method, in which Fig. 16 (a) shows a PL spectrum, Fig. 16 (b) shows damping characteristics of the PL spectrum shown in Fig. 16(a), and Fig. 16(c) is an enlarged view of the PL spectrum;

Figs. 17(a) to (b) are diagrams showing damping characteristics detected by the time-resolved photoluminescence method, in which Fig. 17(a) shows the damping characteristic in high-density quantum nanodots of Example, and Fig. 17(b) shows the characteristic of Comparative Example;

Fig. 18 is a graph showing thickness dependency of Si quantum nanodots relative to a photon energy of a peak wavelength of a PL spectrum;

Fig. 19 is a graph showing diameter dependency of the quantum nanodots relative to a bandgap;

Fig. 20 is a graph showing thickness dependency of the quantum nanodots relative to a bandgap;

Figs. 21(a) to (b) are diagrams showing an IV property of the two-dimensional quantum nanodot array having an intermediate layer, in which Fig. 21(a) is the case of Example where a spacing between the quantum nanodots is 12 nm, and Fig. 21(b) is the case of Comparative Example where a spacing between the quantum nanodots is 30 nm or more;

Figs. 22 (a) to (c) are graphs each showing a result of measurement of absorption coefficient detected by UV-visible-near infrared spectroscopy; in which Fig. 22(a) shows the case of a 5 nm-thick SiC film, Fig. 22 (b) shows the case of a two-dimensional Si quantum nanodot array of Example having an intermediate layer comprising a Sic film, and Fig. 22(c) shows the case of a two-dimensional Si quantum nanodot array of Example having an intermediate layer comprising $SiO_2$ film;

Figs. 23(a) to (c) are graphs each showing Tauc plot, in which Fig. 23 (a) shows the case of a 5 nm-thick SiC film, Fig. 23(b) shows the case of a two-dimensional Si quantum nanodot array of Example having an intermediate layer comprising a Sic film, and Fig. 23(c) shows the case of a two-dimensional Si quantum nanodot array of Example having an intermediate layer comprising $SiO_2$ film;

Figs. 24(a) to (b) are graphs for comparing results of measurement of absorption coefficients of two-dimensionally arranged quantum nanodot arrays. Fig. 24(a) as well as Fig. 24(b) show the result of Example and the result of Comparative Example;

Figs. 25(a) to (g) are diagrams showing a method for producing a two-dimensional quantum nanodot array comprising GaAs in sequence;

Fig. 26 is a diagram showing PL spectrums of GaAs after NB etching and conventional plasma etching;

Fig. 27 is a scanning electron microscopic image of a surface of Listeria ferritin which is two-dimensionally arranged on a NB oxide film formed on GaAs;

Fig. 28 is a figure showing FTIR spectrums measured by Fourier transform infrared spectroscopy of a GaAs surface after oxygen radical treatment;

Fig. 29 is a diagram showing a scanning electron microscopic image of a cross-section after NB etching on GaAs;

Fig. 30 is a diagram showing a scanning electron microscopic image of a surface of a two-dimensionally arranged GaAs quantum nanodot array;

Figs. 31(a) to (b) are sectional views showing structures of solar cells, in which Fig. 31(a) shows the case of using Si quantum nanodots, and Fig. 31(b) ahows the case of using an SiC layer alone;

Fig. 32 is a diagram showing a scanning electron microscopic (SEM) image of a cross-section of a solar cell using the produced Si quantum nanodots;

Figs. 33(a) to (c) are graphs each showing a result of measurement of absorption coefficient detected by UV-visible-near infrared spectroscopy; in which Fig. 33(a) shows the case of a film comprising a 3 nm-thick SiC layer and Si quantum nanodots, Fig. 33(b) shows the case of a film comprising a 3 nm-thick $SiO_2$ layer and Si quantum nanodots, and Fig. 33(c) shows the case of a film comprising a 5 nm-thick SiC layer alone;

Figs. 34(a) to (b) are diagrams on two-dimensional quantum nanodots having an intermediate layer, in which Fig. 34(a) shows an IV property and Fig. 34(b) shows space probability of electrons;

Figs. 35(a) to (b) are graphs showing measurement results of light absorption coefficients of solar cells, in which Fig. 35(a) shows the case of a solar cell having a 2 nm-thick SiC layer and a 4 nm-thick quantum nanodots, and Fig. 35(b) shows the case of a solar cell having a 2 nm-thick SiC layer;

Fig. 36 is a diagram showing IV properties of the solar cells; and

Fig. 37 is a diagram showing a relationship between a wavelength and external quantum efficiency of each of the solar cells.

Reference Sings List

1, 10, 15: two-dimensionally arranged quantum nanodot array
2: substrate
3: quantum nanodot
4: insulating layer
6: intermediate layer
6a: first intermediate layer
6b: second intermediate layer
7: p-layer
8, 24: n-layer electrode
9, 25: p-layer electrode
10a: active layer
11: n-layer
20, 25, 28: solar cell
21: first solar cell layer
22: second solar cell layer
23: third solar cell layer
26: protection film
30: semiconductor laser diode
31: poly-Si
32: $SiO_2$ film
33: Listeria ferritin
34: two-dimensional array comprising iron oxide cores
34a: iron oxide core
36: natural oxide film
38: GaAs oxide film
40: deposition apparatus using neutral particles
50: reaction chamber
53: semiconductor wafer
54: support table
55, 67: gas introduction port
56: discharge mechanism
60: neutral particle beam generator
62: plasma chamber
68: coil
69: high frequency power source
71, 73: direct current power source
70: anode electrode
72: cathode electrode
74: low frequency power source

Description of Embodiments

Hereinafter, the present invention will be described more specifically by way of embodiments and with reference to the drawings.

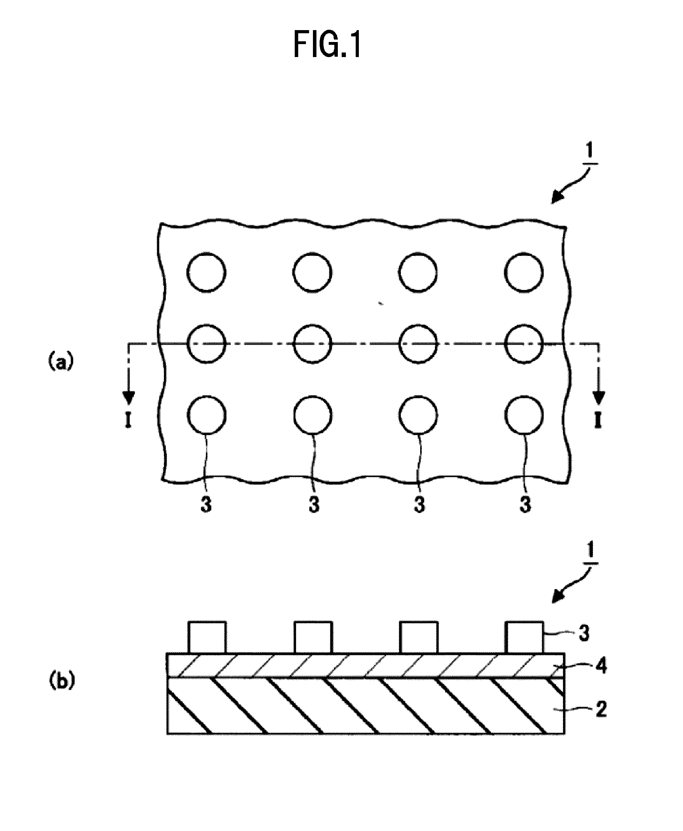

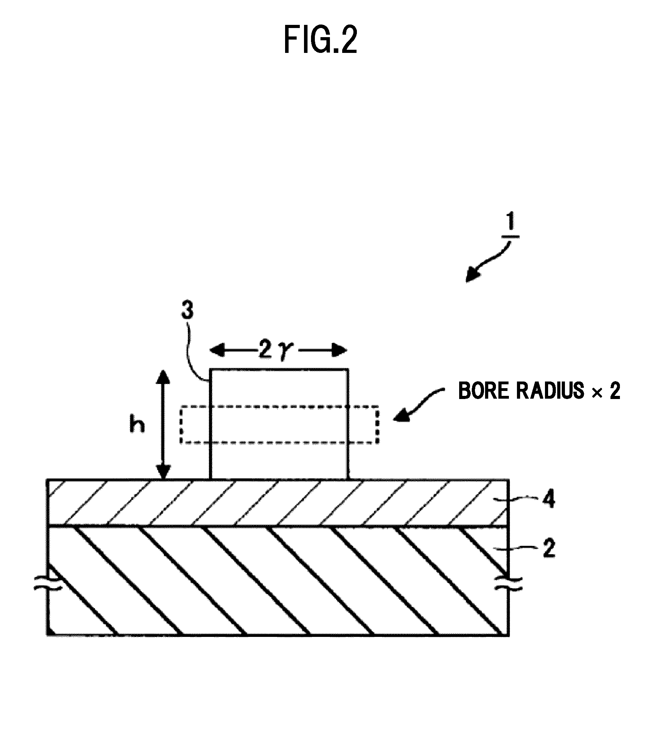

Figs. 1(a) to (b) are diagrams showing a structure of a two-dimensionally arranged quantum nanodot array 1 according to the present invention, in which Fig. 1(a) is a plan view, and Fig. 1(b) is a sectional view taken along a line I-I of Fig. 1(a). Fig. 2 is a schematic enlarged sectional view showing quantum nanodots 3 of Fig. 1.

Referring to Fig. 1, the two-dimensionally arranged quantum nanodot (hereinafter abbreviated to "two-dimensional quantum nanodot") 3 is formed on a substrate 2. Each of the quantum nanodots 3 comprises a semiconductor and has such dimensions that cause a quantum effect. As the semiconductor, a material comprising an inorganic substance or an organic substance may be used. Examples of the semiconductor comprising inorganic substance include a single element semiconductor such as Si and Ge, a compound semiconductor, a mixed crystal of a plurality of compound semiconductors, and the like. As the substrate 2, a substrate material which allows formation of the quantum nanodots 3 on a surface of the substrate 2 may be used. More specifically, a substrate 2 of the semiconductor or a substrate 2 comprising a glass or quartz glass may be used. As shown in Fig. 1 and Fig. 2, a substrate in which an insulating film 4 such as an oxide film is formed on the semiconductor substrate 2 may be used.

Referring to Fig. 2, the quantum nanodot 3 has such a size that the dimensions in two-dimensional directions are not more than twice a bore radius of an exciton in the semiconductor. The quantum nanodot 3 has a thickness in a vertical direction with respect to the two-dimensional directions. In the case where the semiconductor is Si, the bore radius of the exciton in Si is about 5 nm. Hereinafter, the bore radius of exciton in Si will be simply referred to as "bore radius" in some cases in the present specification.

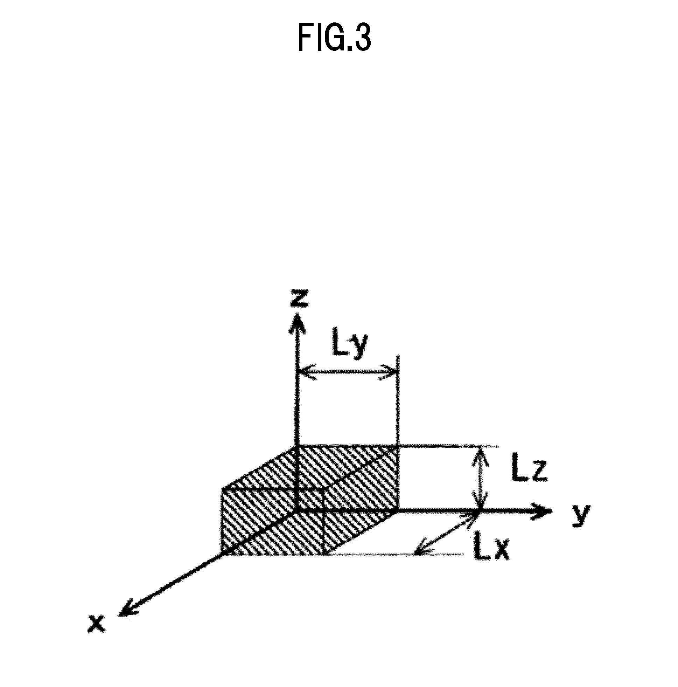

Fig. 3 is a diagram showing dimensions of the quantum nanodot 3. As shown in Fig. 3, the quantum nanodot 3 has the dimensions Lx, Ly, and Lz in xyz- directions. Here, the z-direction is a direction of a thickness of the cross-section structure shown in Fig. 1.

An electronic energy of the quantum nanodot 3 shown in Fig. 3 is represented by the following formula (1) (see Non-Patent Literature 7).

[Math. 1]

$$E(n,m,l) = (\hbar^2/2m^*) \left\{ \left( (n\pi/L_x)^2 + \left( n\pi/L_y \right)^2 + \left( n\pi/L_z \right)^2 \right) \right\} \qquad (1)$$

In the above formula, each of n, m, and 1 is a quantum number; h is Planck's constant/$2\pi$; and m* is an effective mass of the semiconductor forming the quantum nanodot 3.

In the ground state of n=m=l=1, the electronic energy is decided when Lx, Ly, and Lz are decided. Hereinafter, the dimensions of the quantum nanodot are referred to as "outer diameter" in the present specification. The outer diameter is a diameter when an area feature of the quantum nanodot is approximated to a circle.

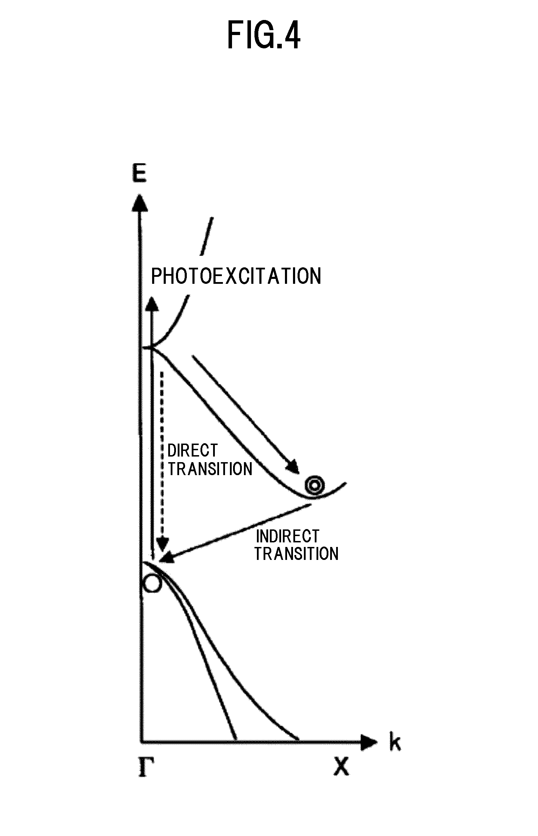

The quantum nanodots may be disposed at a spacing of 1 to 10 nm. In the case where the quantum nanodot 3 comprises Si, luminescence is realized when a diameter in two-dimensional directions is 6 to 10 nm. There are three types of luminescence of the quantum nanodot 3, namely, defect-derived, Auger effect-derived, and direct transition type-derived, and the direct transition type and the Auger effect type are contemplated in the present invention as described later. The direct transition type, i.e. the direct transition type luminescence, is transition approximate to direct transition. Fig. 4 shows energy band structures illustrating direct transition and indirect transition. As shown in Fig. 4, the direct transition vertically transits in a k-space. On the other hand, in the case of the indirect transition, since horizontal transition is included to change energy to heat and sound which are unnecessary energies for luminescence, i.e. to allow involvement of lattice vibration, it is difficult to realize efficient luminescence.

In the case where the quantum nanodot 3 comprises Si, a surface density of the quantum nanodots 3 may be set to $1\times10^{12}$/cm$^2$ to $5\times10^{12}$/cm$^2$. The surface density can be adjusted by changing the spacing between the quantum nanodots within the range of 1 to 10 nm. In the case where the quantum nanodot is formed of Si, a half value of a 665 nm-luminescence peak in photoluminescence characteristics excited at 400 nm, for example, is about 0.2 eV.

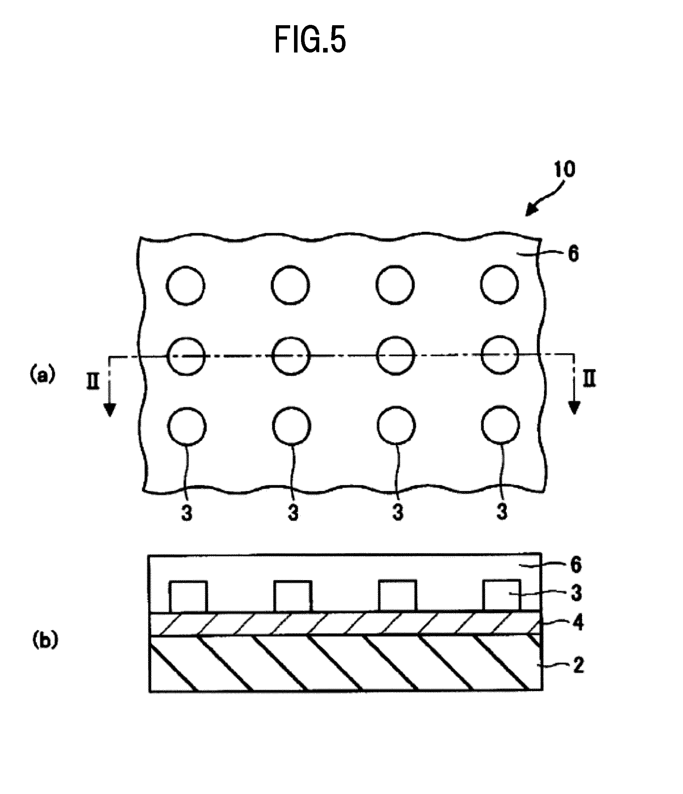

Figs. 5(a) to (b) are diagrams of another technical structure of the two-dimensionally arranged quantum nanodot array, in which Fig. 5(a) is a plan view, and Fig. 5(b) is a sectional view taken along a line II-II of Fig. 5(a).

A two-dimensional quantum nanodot array 10 shown in Fig. 5 is different from the two-dimensional quantum nanodot array 1 of Fig. 1 in the feature of arranging an intermediate layer 6 between adjacent quantum nanodots 3. The intermediate layer 6 comprises a semiconductor or an insulator. The intermediate layer 6 may be a semiconductor or an insulator having a bandgap larger than that of the quantum nanodot 3. The intermediate layer 6 may be any one of SiO$_2$, Si$_3$O$_4$, and SiC, for example.

In the two-dimensionally arranged quantum nanodot array 10 shown in Fig. 5, another layer comprising the quantum nanodots 3 may be provided to form a multilayer.

An optical absorption property and a transport property of the two-dimensional quantum nanodot array 10 are controlled by the intermediate layer 6 and the distance between the adjacent quantum nanodots 3.

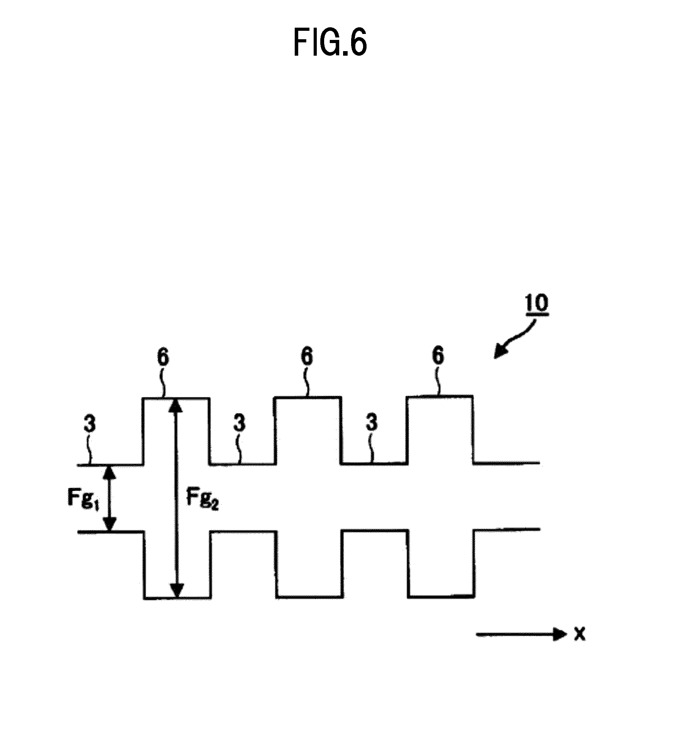

Fig. 6 is a diagram showing a band of the two-dimensional quantum nanodot array 10 of Fig. 5. Fig. 6 is a band diagram when the layers each comprising the quantum nanodots 3 of the two-dimensional quantum nanodot array 10 are formed as a multilayer. Fig. 6 shows the case where the bandgap of the intermediate layer 6 is larger than that of the quantum nanodot 3, in which the bandgap of the quantum nanodot 3 is Eg$_1$, and the bandgap of the intermediate layer 6 is Eg$_2$.

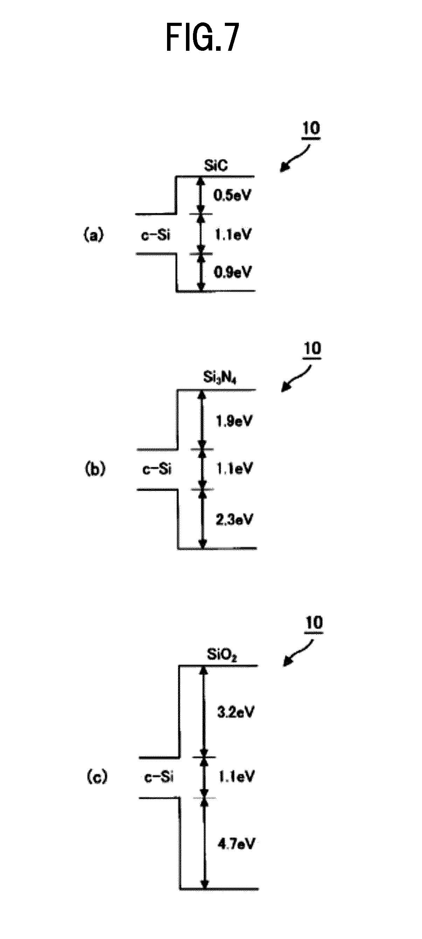

Figs. 7(a) to (c) are specific examples of band diagrams obtained by using Si for the quantum nanodots 3 and various intermediate layers 6, in which the intermediate layers 6 of Figs. 7(a), 7(b), and 7(c) are SiO$_2$, Si$_3$O$_4$, and SiC, respectively.

Fig. 7 shows the case where the bandgap of the intermediate layer 6 is larger than that of the quantum nanodot 3, in which the bandgap of the quantum nanodot 3 is Eg$_1$, and the bandgap of the intermediate layer 6 is Eg$_2$. As shown in Fig. 7, the bandgap of Si is 1.1 eV, while the bandgaps of Sic, Si$_3$N$_4$, and SiO$_2$ are 2.5 eV, 5.3 eV, and 9 eV, respectively.

The two-dimensional quantum nanodot array 10 having the intermediate layer 6 has a so-called superlattice structure. In the present specification, a two-dimensional quantum nanodot array 15 having the intermediate layer 6 is also referred to as a superlattice quantum nanodot layer.

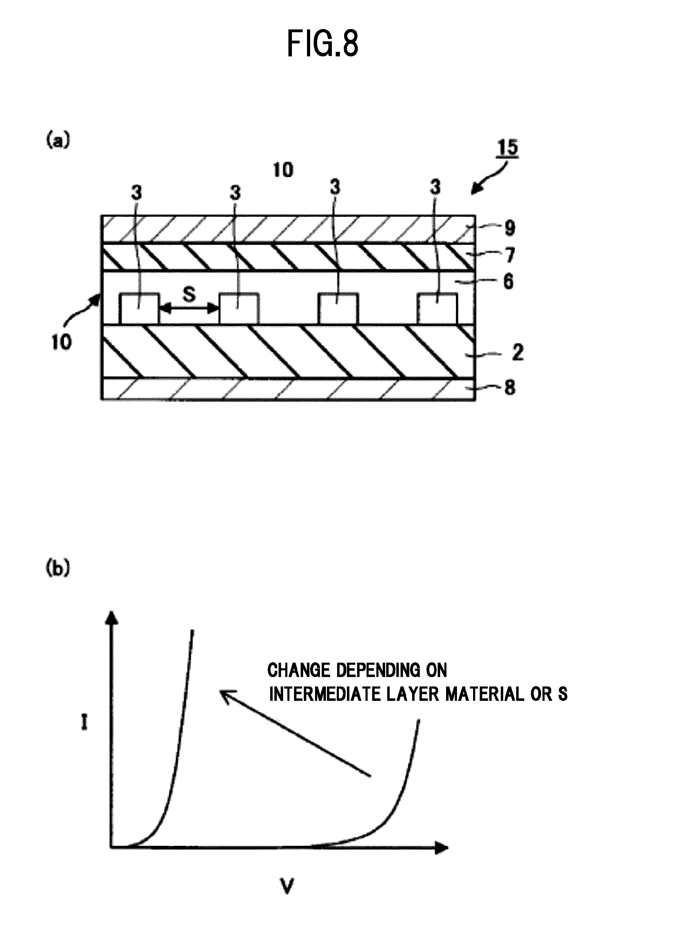

Figs. 8(a) to (b) are diagrams illustrating a transport property of the two-dimensional quantum nanodot array structure 15 having the intermediate layer 6, in which Fig. 8(a) shows the structure, and Fig. 8(b) schematically shows an IV property.

The two-dimensionally arranged quantum nanodot array structure 15 of Fig. 8 (a) is a diode and has a structure that a two-dimensional quantum nanodot array 10 having the intermediate layer 6 is formed on an n-type substrate 2 and that a p-layer 7 is further formed on the intermediate layer 6. In the case where the quantum nanodot array 10 comprises Si, the n-type substrate 2 and the p-layer 7 can also be formed of Si.

Fig. 8(b) shows that the IV property is changed depending on a spacing S between the adjacent quantum nanodots 3, i.e. a width of the intermediate layer 6 inserted between the adjacent quantum nanodots 3, in the diode structure 15. When the spacing S is reduced, a current flow is facilitated, i.e. the transport property is improved. By keeping the spacing S to the nanometer order, the transport property is further improved due to direct tunnel injection. The transport property can be also changed by material of the intermediate layer 6. In the two-dimensional quantum nanodot array 10 having the quantum nanodots 3 comprising Si and the intermediate layer 6 comprising SiC, electric conductivity is higher and the transport property is improved as compared to case of using $SiO_2$ for the intermediate layer 6.

As described above, in the two-dimensionally arranged quantum nanodot array 10, the transport property of the two-dimensional quantum nanodot array 10 is controlled by the combination of the intermediate layer 6, the distance between the adjacent quantum nanodots 3, and the bandgap of the material forming the intermediate layer 6. An improvement in carrier transport property depends on overlapping of wavefunctions of quantum dots. In other words, in the case where the distance between the quantum nanodots is reduced and the intermediate layer 6 having small bandgap is used, wavefunctions of the quantum nanodots 3 are overlapped to form a miniband. As a result, the tunnel transfer of the carriers formed by the quantum nanodots 3 is accelerated to improve the carrier transport property. When the spacing of the quantum nanodots is reduced, a single electron tunneling effect is produced, i.e. Coulomb blockade is generated, to diminish a voltage.

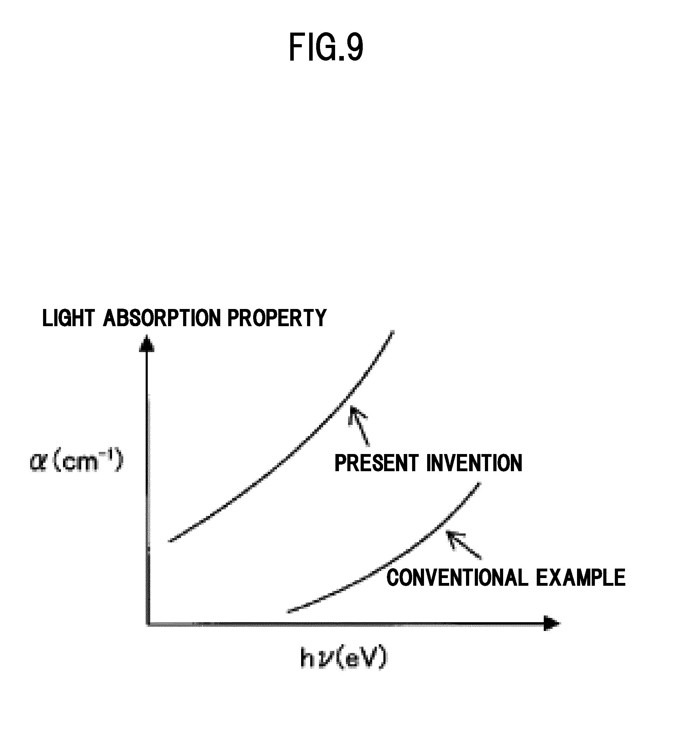

Fig. 9 is a diagram illustrating a light absorption property of the two-dimensional quantum nanodot array 10 having the intermediate layer 6. As shown in Fig. 9, it is possible to enhance the light absorption property by changing the material of the intermediate layer 6 from $SiO_2$ to SiC, for example, in the two-dimensional quantum nanodot array 10 having the intermediate layer 6. By using $SiO_2$, $Si_3O_4$, SiC, or the like for an area between the quantum nanodots 3, i.e. for the intermediate layer 6 or the interlayer, the light absorption and carrier transport properties are controlled.

Hereinafter, a semiconductor device using the two-dimensionally arranged quantum nanodot array 10 of the present invention having the intermediate layer 6 will be described.

(Solar Cell)

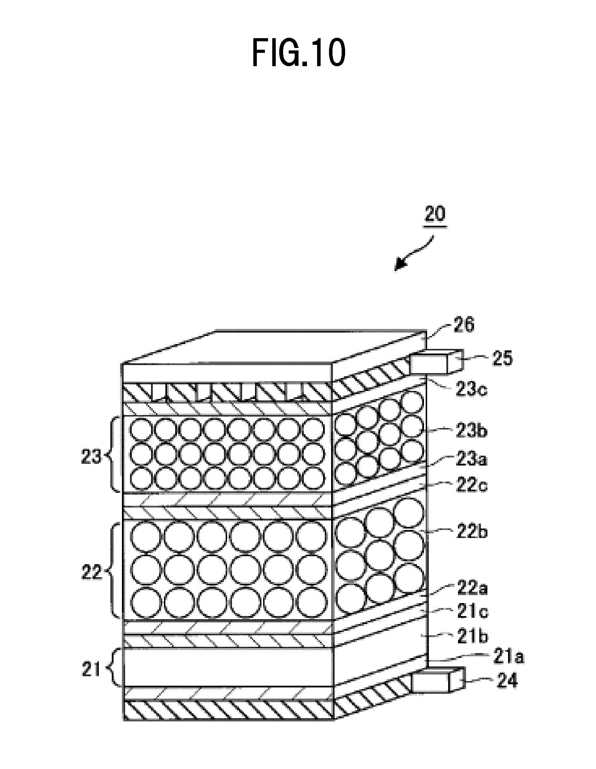

Fig. 10 is a perspective view showing a structure of a solar cell 20 formed by two-dimensionally arranging the quantum nanodot array 10 of the present invention having the intermediate layer 6.

As shown in Fig. 10, the solar cell 20 is provided with a first solar cell layer 21 comprising Si, a second solar cell layer 22 formed on the first solar cell layer 21, a third solar cell layer 23 formed on the second solar cell layer 22, a p-layer electrode 24 formed on the first solar cell layer 21, and an n-layer electrode 25 formed on an n-layer 23c which is the uppermost layer of the third solar cell layer 23.

The first solar cell layer 21 is a so-called pin diode in which a p-layer 21a, an i-layer 21b, and an n-layer 21c comprising Si are laminated in this order, and the pin diode having a bandgap (Eg) of 1.1 eV and responding to a wavelength of about 1100 nm.

The second solar cell layer 22 is provided with a p-layer 22a formed on the n-layer 21c, a first superlattice quantum nanodot layer 22b formed on the p-layer 22a, and an n-layer 22c formed on the first superlattice quantum nanodot layer 22b. The structure of the second solar cell layer 22 is obtained by changing the i-layer 21b of the first solar cell layer 21 to the first superlattice quantum nanodot layer 22b having a bandgap different from that of the i-layer 21b. The quantum nanodot 3 in the first superlattice quantum nanodot layer 22b has a bandgap (Eg) of 1.5 eV and responds to a wavelength of about 800 nm. The bandgap (Eg) of the quantum nanodot 3 is controlled by adjusting the size of the quantum nanodot 3 as described above. The first superlattice quantum nanodot layer 22b is provided with the monolayer structure two-dimensional quantum nanodot array comprising the quantum nanodot 3 and the intermediate layer 6 shown in Fig. 5. The first superlattice quantum nanodot layer 22b may be obtained by laminating a plurality of two-dimensional quantum nanodot arrays having an identical bandgap. In other words, the first superlattice quantum nanodot layer 22b may have a structure that a plurality of, e.g. 5 to 10 layers of, the monolayer structure two-dimensional quantum nanodot arrays are laminated.

A structure of the third solar cell layer 23 is the same as that of the second solar cell layer 22. The third solar cell layer 23 is provided with a p-layer 23a formed on the n-layer 22c of the second solar cell layer 22, a second superlattice quantum nanodot layer 23b formed on the p-layer 23a, and an n-layer 23c formed on the second superlattice quantum nanodot layer 23b. The quantum nanodot 3 in the second superlattice quantum nanodot layer 23b has a bandgap (Eg) of 2 eV, which is different from that of the first superlattice quantum nanodot layer 22b, and responds to a wavelength of about 600 nm. The bandgap (Eg) of the quantum nanodot 3 is controlled by adjusting the size of the quantum nanodot 3 as described above. The second superlattice quantum nanodot layer 23b is provided with the monolayer structure two-dimensional quantum nanodot array comprising the quantum nanodot 3 and the intermediate layer 6 shown in Fig. 5. The second superlattice quantum nanodot layer 23b may be obtained by laminating a plurality of two-dimensional quantum nanodot arrays having an identical bandgap. In other words, the second superlattice quantum nanodot layer 23b may have a structure that a plurality of, e.g. 5 to 10 layers of, the monolayer structure two-dimensional quantum nanodot arrays are laminated.

A protection film 26 may further be coated on the n-layer electrode 25 formed on the uppermost layer of the third solar cell layer 23. The protection film 26 is preferably a light transmitting material. As the protection film 26, a transparent electrode such as an oxide formed of indium and tin (Indium Tin Oxide; hereinafter referred to as ITO) may be used.

The above-described solar cell 20 has a so-called tandem type solar cell structure in which the p-i-n type first solar cell layer 21, the second solar cell layer 22, and the third solar cell layer 23 are serially connected. Since wavelengths of the layers 21, 22, and 23 respectively correspond to about 1100 nm, about 800 nm, and about 600 nm, electrons and holes are efficiently formed in an infrared region and a visible light region of solar light.

The intermediate layer 6 of the first and second superlattice quantum nanodot layers is so provided that the electrons and holes generated by irradiation with solar light are efficiently transported. Therefore, for example, the intermediate layer 6 may be SiC, and the spacing between the quantum nanodots 3 may be of a nanometer order which readily causes the tunnel injection. The spacing may be 2 to 6 nm, preferably 3 nm or less, for example.

(Semiconductor Laser)

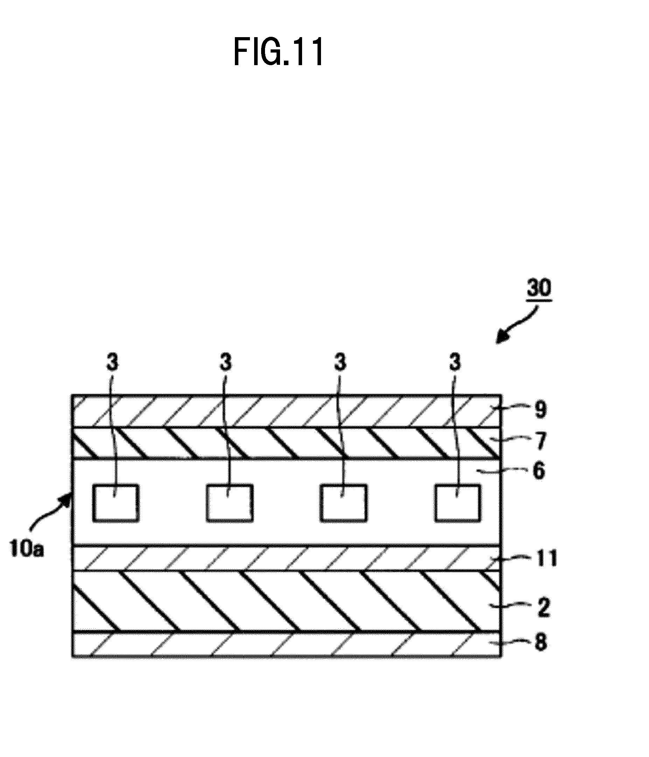

Fig. 11 is a sectional view showing a structure of a semiconductor laser diode 30 using the two-dimensionally arranged quantum nanodot array 10 of the present invention. An intermediate layer 6 is filled between quantum nanodots 3.

As shown in Fig. 11, the semiconductor laser diode 30 using the two-dimensional quantum nanodot array 10 having the intermediate layer 6 comprises layers in which an n-layer 11 formed on a substrate 2, an active layer formed of two-dimensionally arranged quantum nanodot array 10a formed on the n-layer 11, and a p-layer 7 formed on the two-dimensionally arranged quantum nanodot array 10 are laminated in this order. An n-layer electrode 8 is formed on the substrate 2 side, and a p-layer electrode 9 is formed on the p-layer 7.

In the semiconductor laser diode 30, the two-dimensional quantum nanodot array 10 having the interlayer 6 operates as the active layer 10a. In the active layer 10a, the quantum nanodot 3 may be GaAs, and the intermediate layer 6 may be AlGaAs. Since high luminescence intensity is required in the case of a quantum dot laser, a spacing of the quantum nanodots 3 in the active layer 10a is such that a miniband is not formed in the active layer 10a. Therefore, in order that the miniband is not realized in the active layer 10a, the spacing of the quantum nanodots 3 may preferably be 6 to 10 nm.

Further, in order to efficiently confine the carrier and light, an n-type clad layer may be provided between the n-layer 11 and the active layer 10a, and a p-type clad layer may be provided between the p-layer 7 and the active layer 10a. Materials for the n-type and p-type clad layers may be those having a larger bandgap than those of the n-layer 11 and the p-layer 7.

(Production Method)

Hereinafter, a method for producing the two-dimensionally arranged quantum nanodot arrays 1 and 10 of the present invention will be described.

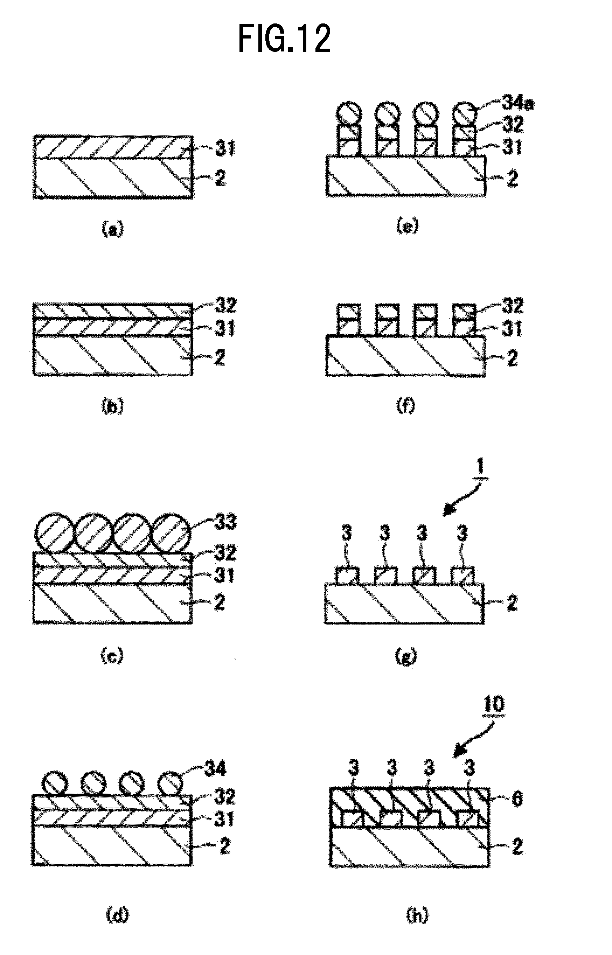

Figs. 12(a) to (h) are diagrams sequentially showing the production method of the two-dimensional quantum nanodot arrays 1 and 10. Hereinafter, (a) to (h) will be described one by one.

(a) A semiconductor layer 31 is formed on a substrate 2. In the following description, the semiconductor layer 31 is a poly-Si layer.

(b) 3 nm of a surface oxide film ($SiO_2$) 32 is deposited on the poly-Si layer 31 by using an apparatus with the neutral particles developed by the inventors (see Patent Literature 1). Hereinafter the film deposited by using the apparatus with neutral particles is also called NB (Neutral Beam) film. The apparatus using neutral particles is also capable of performing etching, and such etching is referred to as NB etching.

(c) A protein 33 containing a metal is two-dimensionally deposited on SiO$_2$ 32. Since the dimensions of the quantum nanodot 3 are decided based on dimensions of the metal contained in the protein, a protein containing a metal which enables to obtain the quantum nanodot 3 of 10 nm or less is used. The metal-containing protein may be Listeria ferritin 33, for example.

Here, Listeria ferritin 33 is a composite formed of a protein and a metal and is also called a bioconjugate. In a living body, the one formed of four protein molecules containing heme groups in each of which an iron oxide (Fe$_2$O$_3$) core is bound to the center of a cyclic compound called porphyrin is hemoglobin. Listeria ferritin is obtained by a culture in E. Coli. The iron oxide (Fe$_2$O$_3$) core is simply called "iron core" in some cases.

(d) Next, shells of Listeria ferritin 33 are removed by annealing in an oxygen atmosphere. Thus, a state in which two-dimensional arrays 34 formed of the iron oxide cores are deposited on SiO$_2$ is attained. The two-dimensional arrays 34 formed of these iron oxide cores are used as an etching mask for the following step.

(e) An NF$_3$ gas/hydrogen radical treatment is performed as etching to remove the SiO$_2$ 32 on a surface, and the poly-Si 31 is removed by NB etching. In this step, since the SiO$_2$ 32 is subjected to isotropic etching by the NF$_3$ gas/hydrogen radical treatment by using the iron oxide cores 34a as a mask, it is possible to change dimensions of the SiO$_2$ 32 positioned under the iron oxide cores 34a by changing an etching time. After the NF$_3$ gas/hydrogen radical treatment, anisotropic (vertical) NB etching may further be performed by using the iron oxide cores 34a and the SiO$_2$ 32 as a mask. In this step, the shape of the mask is transferred as Si quantum nanodots. The anisotropic etching can be performed by using a neutral particle beam (NB) with chlorine. In the anisotropic etching, the etching is further performed though an etching rate of the silicon oxide film is slow. Thus, the dimensions of the quantum nanodot 3 are decided by the dimensions of SiO$_2$ 32. As described above, the dimension control of the quantum nanodot 3 is realized. The semiconductor used for the quantum nanodot is Si in the foregoing description, but a compound semiconductor such as GaAs may alternatively be used.

(f) Finally, the iron oxide cores 34a are removed by HCl wet etching. By the steps described hereinabove, the two-dimensionally arranged quantum nanodot arrays 1 are formed.

[0049] Hereinafter, a method for producing two-dimensionally arranged quantum nanodot array 10 of the present invention having an intermediate layer 6 will be described with reference to Figs. 12(g) to 12(h).

The following steps are performed after performing the steps (a) to (f) in the above-described two-dimensional quantum nanodot array 1. A material of the intermediate layer 6 is SiC in the following description.

(g) The surface SiO$_2$ layer is removed by NF$_3$ treatment or the like. SiC having a larger thickness than the quantum nanodot 3 is deposited on the Si quantum dots by sputtering or the like.

By the above-described step, the intermediate layer 6 is formed in clearances of the quantum nanodots 3 as shown in Fig. 12(h) to form the two-dimensional quantum nanodot arrays 10 having the intermediate layers 6.

The present invention will be described in more detail by the examples given below.

Examples

Uniform quantum nanodots 3 having a diameter of less than 10 $\mu$m were formed by using Si and using Listeria ferritin 33 in place of conventional ferritin. In order to enhance crystallinity, neutral beam etching was employed. A production method will be described below. Steps described below correspond to Fig. 12. Listeria ferritin used in Examples was cultured in E. Coli and their excessive bases were eliminated.

(a) On a Si substrate 2 with an oxide film or a quartz substrate, 6 nm of an amorphous Si 31 was deposited by 6 nm by electron beam evaporation method. Next, poly-Si 31 was obtained by annealing in a nitrogen atmosphere.

(b) By using an apparatus 40 with neutral particles (see Patent Literature 1), a surface oxide film 32 (SiO$_2$) having a thickness of 3 nm was deposited on the poly-Si 31.

Here, the apparatus capable of performing deposition and etching using neutral particles will be described.

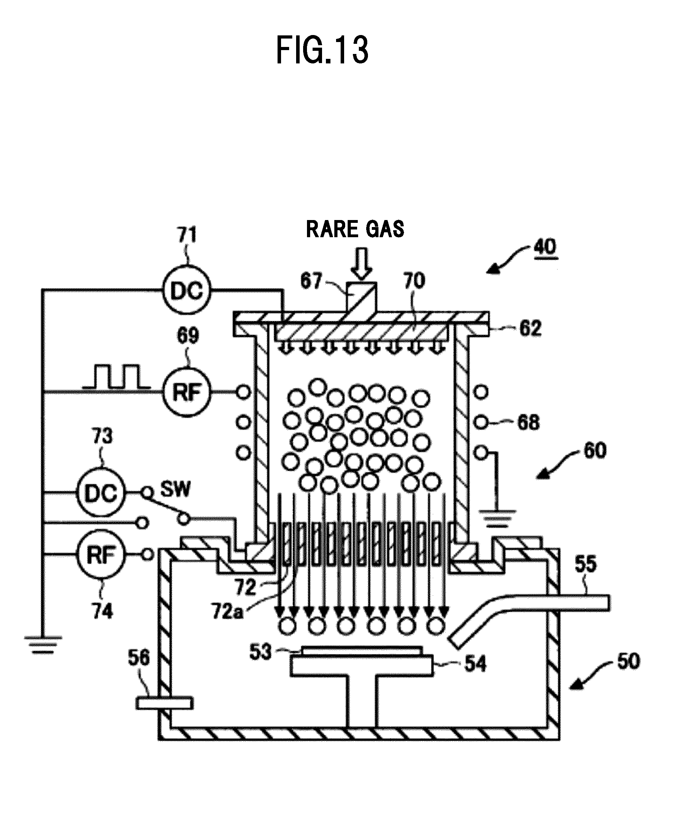

Fig. 13 is a diagram showing the deposition apparatus 40 using neutral particles. The deposition apparatus 40 using neutral particles is provided with a neutral particle beam generator 60 on an upper part of a reaction chamber 50, for example.

The reaction chamber 50 is provided with a support table 54 on which a semiconductor wafer 53 to be processed is placed. The support table 54 has a temperature controller (not shown), and the semiconductor wafer 53 is controlled to a predetermined temperature. The reaction chamber 50 is provided with a gas introduction port 55 and a discharge mechanism 56. The inside of the reaction chamber 50 is maintained to a predetermined pressure by the discharge mechanism 56, and a raw material gas is introduced from the gas introduction port 55 onto the semiconductor wafer 53 on the support table 54. In the case where an etching gas is used as the raw material gas, the deposition apparatus 40 using neutral particles serves as the etching apparatus.

The neutral particle beam generator 60 has a plasma chamber 62 made of quartz, for example. A gas introduction port 67 is provided on an upper part of the plasma chamber 62, and a gas used for the reaction is introduced from the gas introduction port 67 into the plasma chamber 62. A coil 68 is wound around the plasma chamber 62. One end of the coil 68 is grounded, and the other end is connected to a high frequency power source 69. An anode electrode 70 as an upper electrode is provided on an upper part in the plasma chamber 62. The anode electrode 70 is connected to a direct current power source 71 and the high frequency power source 69. A cathode electrode 72 as a lower electrode is provided at the boundary under the plasma chamber 62 and between the neutral particle beam generator 60 and the reaction chamber 50. The cathode electrode 72 is connected to a direct current power source 73 for bias via a switch SW. The direct current power source 73 is a variable power source, and an electric field between the anode electrode 70 and the cathode electrode 72 can be varied by the direct current power source 73. The direct current power source 73 may be connected to a lower frequency power source 74 for bias via the switch SW.

The cathode electrode 72 is made of carbon, for example, and has a plurality of openings 72a. The openings 72a have an aspect ratio (a ratio between a thickness of the cathode electrode 72 and a diameter of the opening 72a) which is set within the range of 10 or more to 20 or less, for example, and an aperture ratio (a ratio of an opening area of the plurality of openings 72a to a surface area of the cathode electrode 72) which is set within the range of 50% or less to 30% or more, for example.

The cathode electrode 72 neutralizes positive charged particles and allows the particles to pass therethrough while blocking electrons and UV light or photons generated from the plasma.

Further, in order to prevent the gas inside the reaction chamber 50 from flowing into the plasma chamber 62, a pressure difference is set between the reaction chamber 50 and the plasma chamber 62. More specifically, the pressure in the reaction chamber 50 is set to 100 mmTorr or more, for example, and the pressure in the plasma chamber 62 is set to 1 Torr or more, for example.

(c) Next, referring back to Fig. 12, as shown in Fig. 12(c), a two-dimensional array of Listeria ferritin 33 was deposited on the $SiO_2$ 32.

(d) Shells of Listeria ferritin 33 were removed by annealing in an oxygen atmosphere. Thus, a state in which two-dimensional arrays 34 formed of iron oxide cores 34a are deposited on $SiO_2$ was attained. The two-dimensional arrays 34 formed of these iron oxide cores 34a were used as an etching mask for the following step.

(e) An $NF_3$ gas/hydrogen radical treatment was firstly performed as etching on the $SiO_2$ 32 on a surface side to remove the $SiO_2$ 32 on the surface side.

Subsequently, the poly-Si 31 was removed by NB etching using the iron oxide cores 34a as a mask.

Each of the thus-formed quantum nanodots comprising Si had a thickness of 4 nm and a diameter of 6 to 7 nm, and an average spacing between the adjacent nanodots was 12.2 nm. A dimensional distribution of the quantum nanodots was 8.3%.

(f) The iron oxide cores 34a were removed by HCl wet etching.

The following steps were performed after (a) to (f) to form an intermediate layer 6 comprising SiC.

(g) The surface $SiO_2$ layer was removed by an $NF_3$ treatment. SiC having a thickness of 5 nm was deposited on the Si quantum nanodots in the high vacuum sputtering chamber. A temperature of the substrate was 550°C, and a SiC sputtering rate was 1 nm/min.

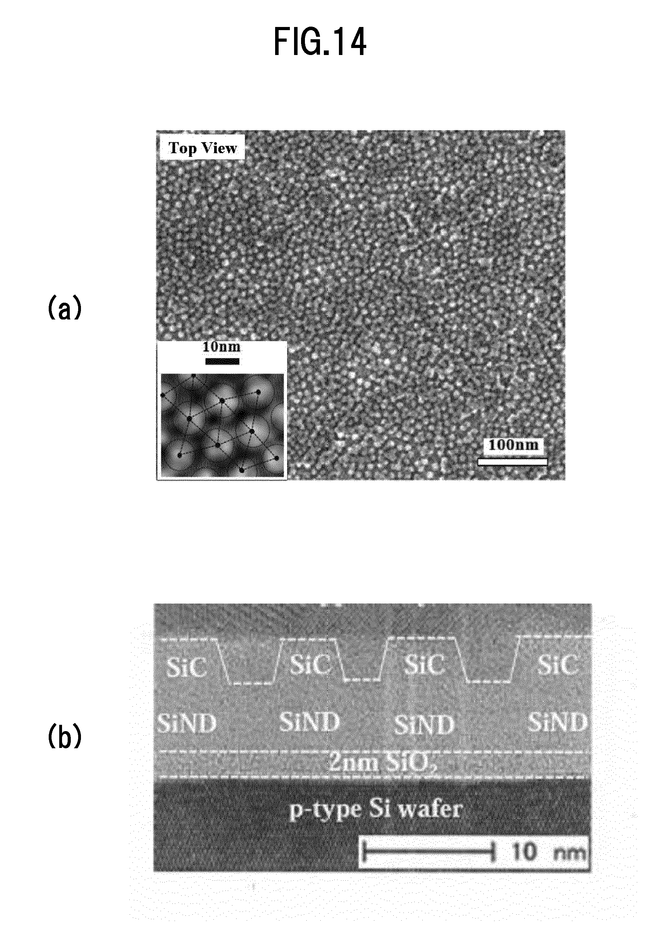

Figs. 14(a) to (b) are diagrams of scanning electron microscopic images of the two-dimensionally arranged quantum nanodot array 10 having the intermediate layer 6 formed by the production method shown in Fig. 12, in which Fig. 14(a) shows a surface thereof, and Fig. 14(b) shows a cross-section thereof. An enlarged SEM image is inserted at the lower left part of Fig. 14(a).

As is apparent from Fig. 14(a), in the formed two-dimensionally arranged quantum nanodot array 10 having the intermediate layer 6, the quantum nanodots 3 had a diameter of 6.4 nm and a surface density of $1.2 \times 10^{12}$/cm$^2$ which was about 1.7 times that of a two-dimensionally arranged quantum nanodot array 10 having an intermediate layer 6 and produced by using a ferritin protein which is described later in this specification.

As is apparent from Fig. 14(b), it is shown that the $SiO_2$ layer 32 on the substrate, the Si quantum nanodots 3, and the intermediate layers 6 were formed. Also, it is shown that the diameters and thicknesses of the Si quantum nanodots 3 are uniform and that the intermediate layer 6 is formed between and on the Si quantum nanodots 3.

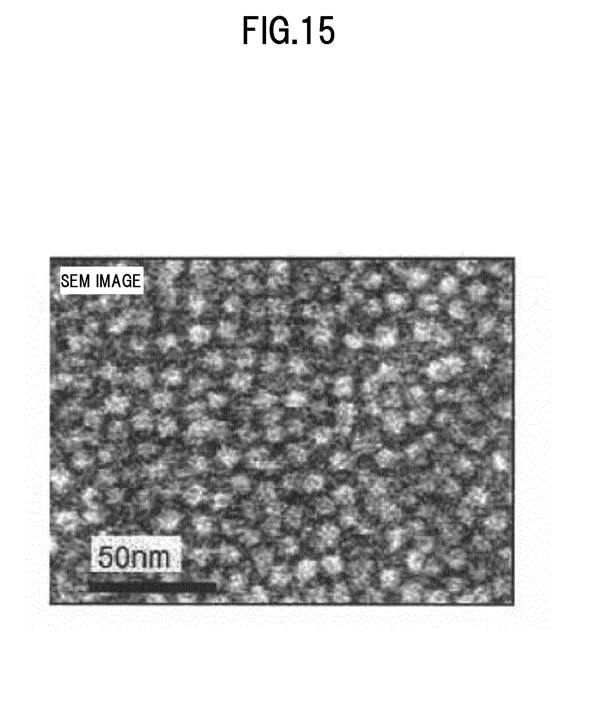

Fig. 15 is a diagram showing a scanning electron microscopic image of a surface of a two-dimensionally arranged quantum nanodot array 10 having an intermediate layer 6 formed by using conventional ferritin, and a surface density of quantum nanodots 3 thereof was $7 \times 10^{11}$/cm$^2$.

From Fig. 14 and Fig. 15, it was proved that the quantum nanodots 3 in the two-dimensionally arranged quantum nanodot array 10 having the intermediate layer 6 produced by the above-described production method has the high orientation and the high density.

As used herein, "high orientation" means that sizes of the quantum nanodots 3 themselves are uniform and the spacings between the adjacent quantum nanodots 3, i.e. the spacings in two-dimensional directions between the adjacent intermediate layers 6, are identical. Also, "the quantum nanodots 3 have the high density" means that the surface density of the quantum nanodots 3 is $1\times10^{12}/cm^2$ or more.

Hereinafter, results of measurements of the thus-produced two-dimensionally arranged quantum nanodot array 10 having the intermediate layer 6 by a time-resolved photoluminescence method will be described.

The time-resolved photoluminescence measurement was performed by cooling the thus-produced sample to 150 K and irradiating the sample with laser light having a wavelength of 400 nm (output: 50 mW).

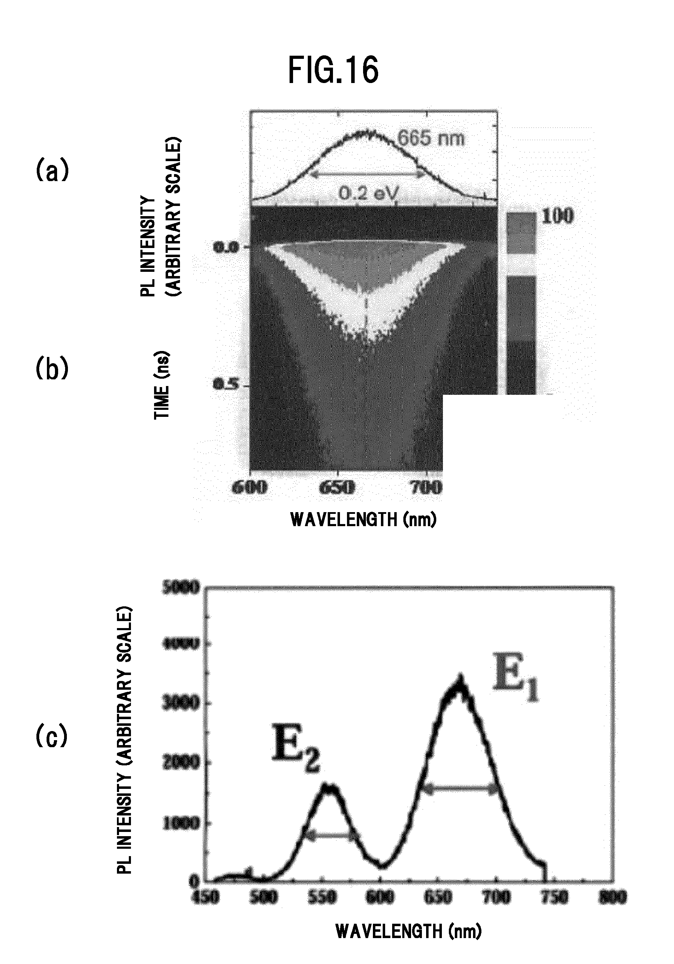

Figs. 16(a) to (c) are diagrams showing measurement results obtained by the time-resolved photoluminescence method, in which Fig. 16(a) shows a PL spectrum, Fig. 16(b) shows damping characteristics of Fig. 16(a), and Fig. 16(c) is an enlarged view of the PL spectrum.

As shown in Fig. 16(a) and 16(c), a spectrum of photoluminescence (also referred to as "PL spectrum") was obtained from the two-dimensionally arranged quantum nanodot array 10 having the intermediate layer 6, and a center wavelength thereof was 665 nm (1.85 eV). A half value width of this spectrum was 0.2 eV. It was proved that the value is considerably narrower than the half value width (0.5 eV) of a sample produced from a conventional Si nanocrystal by self-assembly by heat annealing or ion injection (see Non-Patent Literatures 8 and 9). Further, as a half value width of a PL spectrum of a single crystal Si nanocrystal, 0.1 eV has recently been reported (see Non-Patent Literature 10).

From the damping characteristics of the PL spectrum having the center wavelength of 665 nm shown in Fig. 16(b), it was confirmed that a transition time, i.e. a life, is of the order of ps (picosecond), which is less than 1 ns, and is remarkably short.

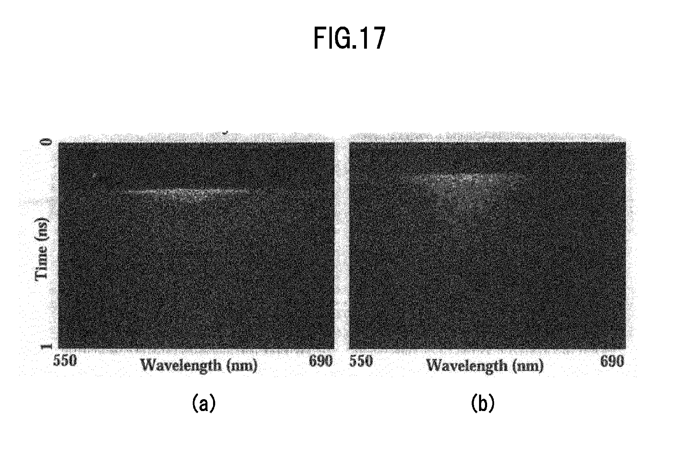

Fig. 17(a) to (b) are diagrams showing damping characteristics detected by the time-resolved photoluminescence method, in which Fig. 17(a) shows the damping characteristic in the high-density quantum nanodots of Example, and fig. 17(b) shows the characteristic of Comparative Example. Low density quantum nanodots were used as Comparative Example. As is apparent from Fig. 17, it was proved that the life of luminescence from the low density quantum nanodots is longer than that of Example.

From the above results, the considerably narrow half value width of the PL spectrum obtained by Example shows that the Si quantum nanodots 3 have the uniform dimensions and shapes and that the direct transition type transition, not the indirect transition as of bulk Si is caused.

(Thickness Dependency of Quantum Nanodots Relative to PL Spectrum)

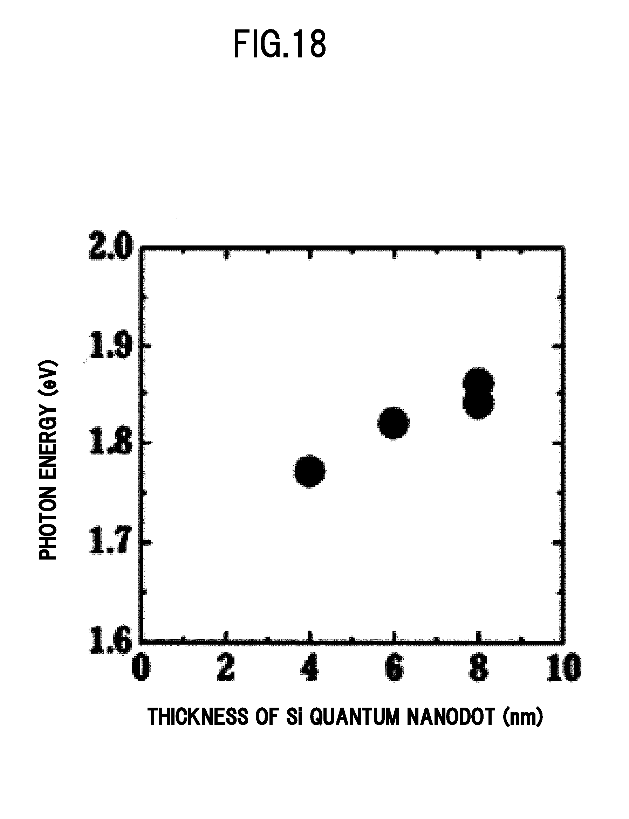

Fig. 18 is a graph showing thickness dependency of Si quantum nanodots 3 relative to a photon energy of a peak wavelength of a PL spectrum. The horizontal axis of Fig. 18 indicates the thickness (nm) of the Si quantum nanodot 3, while the vertical axis indicates the photon energy (eV) of PL spectrum peak wavelength.

As is apparent from Fig. 18, the photon energies when the thicknesses of the Si quantum nanodot 3 are 4 nm, 6 nm, and 8 nm are about 1.78 eV, 1.82 eV, and 1.85 eV, respectively. From the results, it was confirmed that the peak wavelength of the PL spectrum can be changed by varying the thickness of the Si quantum nanodot 3.

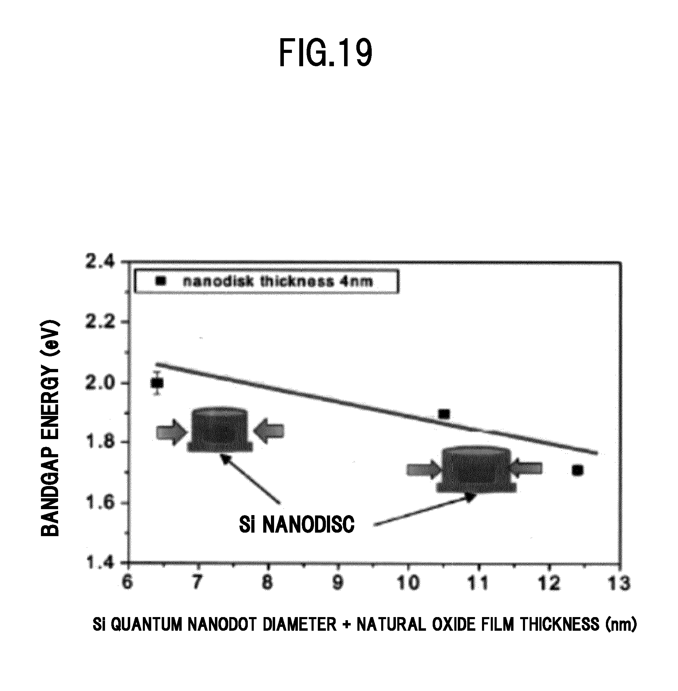

Fig. 19 is a graph showing diameter dependency of the quantum nanodots 3 relative to a bandgap. The horizontal axis indicates a diameter of the Si quantum nanodot 3 and a thickness (nm) of a natural oxide film, and the vertical axis indicates a bandgap energy (eV) detected from the PL spectrum. For comparison, data of the quantum nanodots 3 produced by using conventional ferritin are shown together.

As is apparent from Fig. 19, when the diameter of the Si quantum nanodot 3 of Example is about 6 nm, the bandgap is about 2 eV.

On the other hand, when the diameters of the Si quantum nanodots of Comparative Example are about 10.5 nm and 12.5 nm, the bandgaps are about 1.9 eV and 1.8 eV, respectively.

From the results, the bandgap, i.e. a quantum confinement state, of the quantum nanodots 3 can be changed by varying the diameter of the Si quantum nanodots 3.

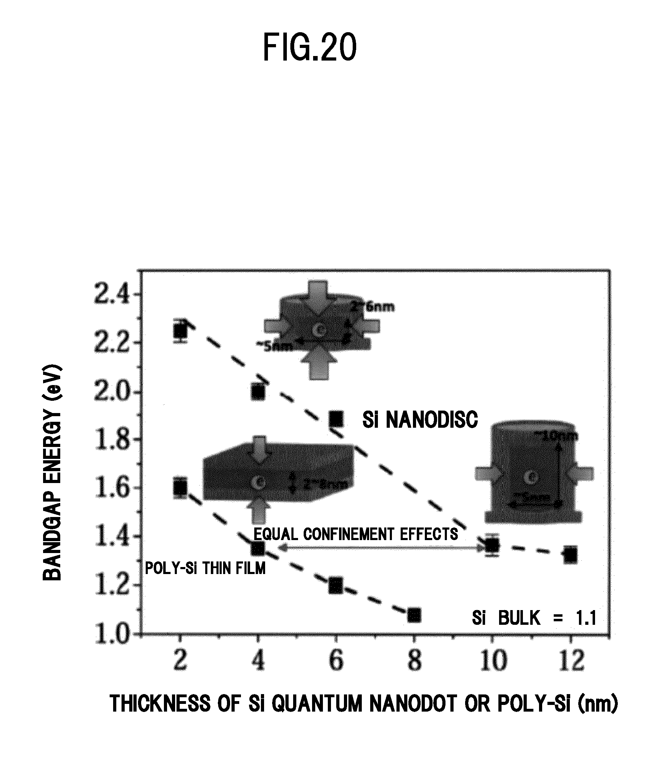

Fig. 20 is a graph showing thickness dependency of the quantum nanodots 3 relative to a bandgap. In Fig. 20, the horizontal axis indicates the thickness (nm) of the Si quantum nanodot 3, and the vertical axis indicates a bandgap energy (eV) detected from the PL spectrum. For comparison, data of the quantum nanodots 3 produced by using conventional ferritin shown in Fig. 19 and quantum nanodots comprising polycrystalline Si and having a thickness of 2 to 8 nm are shown together.

As is apparent from Fig. 20, it is revealed that the quantum confinement effect is attained in the directions of thickness and diameter when the thickness of the Si quantum nanodot 3 of Example is 2 to 6 nm and is smaller than the bore radius (about 5 nm).

It is revealed that a weak quantum confinement effect is attained only in a diameter direction when the thickness of the conventional Si quantum nanodot 3 is 10 nm and is larger than the bore radius (about 5 nm).

In contrast, it was confirmed that a weak quantum confinement effect is attained only in a thickness direction in the case of the poly-Si quantum nanodots.

From the results, the bandgap, i.e. the quantum confinement state, of the quantum nanodots 3 can be changed by varying not only the diameter but also the thickness of the Si quantum nanodots 3 of Examples. A miniband is formed by overlapping of wavefunctions of the quantum nanodots 3 when the spacing between the quantum nanodots 3 is kept to several nanometers or less, thereby improving light absorption property as described later in this specification.

In view of the above, the considerably narrow half value width of the PL spectrum obtained by Example proves that the Si quantum nanodots 3 have the uniform dimensions and shapes and that the obtained Si quantum nanodots 3 are free from defect. Further, in view of the short damping characteristics detected by time-resolved photoluminescence method and the thickness dependency of the Si quantum nanodots 3, it is proved that the direct transition type luminescence is attained by the quantum confinement effect.

Hereinafter, an IV property of the produced two-dimensionally arranged quantum nanodot array 10 having the intermediate layer 6 will be described.

The IV property was detected by measuring a surface of the produced two-dimensional quantum nanodot array 10 having the intermediate layer 6 with a conductive atomic force microscope (AFM).

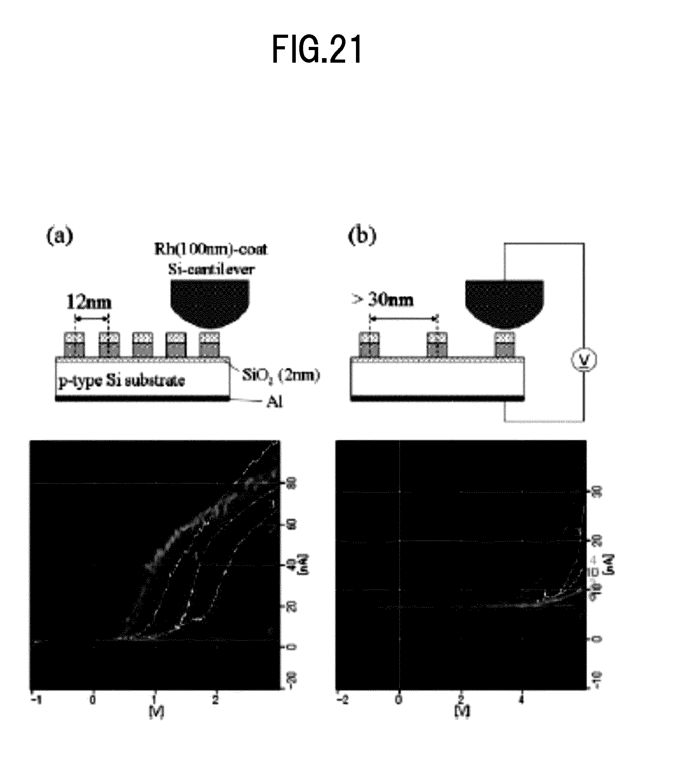

Figs. 21(a) to (b) are diagrams showing the IV property of the two-dimensional quantum nanodot array 10 having the intermediate layer 6, in which Fig. 21(a) shows the case of Examples where a spacing between the quantum nanodots is 12 nm, and Fig. 21(b) shows the case of Comparative Example where a spacing between the quantum nanodots is 30 nm or more.

From Fig. 21(a), it was confirmed that the high density Si quantum nanodots 3 of Examples attain the high conductance and the nonlinear IV property which changes stepwise.

On the other hand, from Fig. 21(b), it was confirmed that it is much more difficult for current to flow in the Si quantum nanodots 3 of Comparative Example than those of Examples, resulting in low conductance.

In view of the above, it is estimated that since the Si quantum nanodots 3 are closely arranged and are bonded to the intermediate layer 6 in the surface, a miniband is formed in the two-dimensional quantum nanodot array 10 having the intermediate layer 6.

Hereinafter, an absorption property of the produced two-dimensional quantum nanodot array 10 having the intermediate layer 6 will be described.

The absorption property of the produced two-dimensional quantum nanodot array 10 having the SiC intermediate layer 6 was measured by using a UV-Visible-Near Infrared (UV-VIS-NIR) spectrophotometer. An SiC film having a thickness of 5 nm was also measured as Comparative Example.

An absorption coefficient ($\alpha$) in each of the photon energies was calculated by the formula (2) shown below.
[Math. 2]

$$\ln\left\{I_0 / I \,(1 - R^2)\right\} = \alpha\, d \qquad (2)$$

In the formula, $I_0$ is intensity of incident light; I is intensity of transmitted light; R is a reflection ratio; and d is a thickness of the quantum nanodot 3.

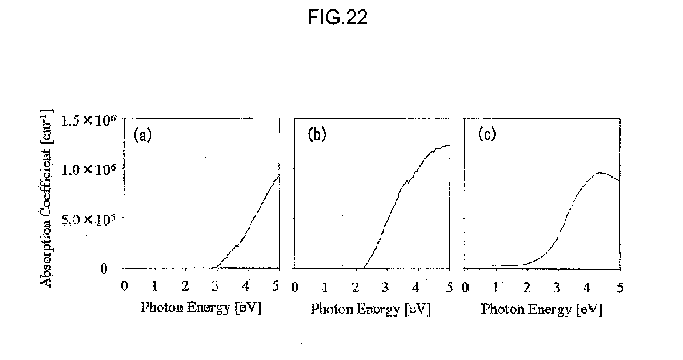

Figs. 22(a) to (c) are graphs showing measurement results of absorption coefficients detected by UV-visible-near infrared spectroscopy; in which Fig. 22(a) shows the case of a 5 nm-thick SiC film, Fig. 22 (b) shows the case of the two-dimensionally arranged Si quantum nanodot array of Example having intermediate layer 6 comprising SiC film, and Fig. 22 (c) shows the case of the two-dimensional Si quantum nanodot array of Example having intermediate layer 6 comprising SiO$_2$ film. In Fig. 22, the horizontal axis indicates a photon energy (eV), and the vertical axis indicates an absorption coefficient (cm$^{-1}$). In the two-dimensional Si quantum nanodot array 10 of Example having the intermediate layer 6 of SiC film, each of the thicknesses of the SiC film and Si is 4 nm. In the two-dimensional Si quantum nanodot array 10 of Example having the intermediate layer 6 of SiO$_2$ film, the thickness of the SiO$_2$ film is 3 nm, and the thickness of Si is 4 nm.

From Figs. 22(b) and 22(c), absorption edges of the two-dimensionally arranged Si quantum nanodot arrays 10 of Examples are hardly different from each other. In Examples, it was confirmed that the two-dimensional quantum nanodot array 10 having the intermediate layer 6 of SiC film has a larger absorption coefficient than the two-dimensional quantum nanodot array 10 having the intermediate layer 6 of SiO$_2$ film. The larger absorption coefficient of the two-dimensionally arranged quantum nanodot array 10 having the intermediate layer 6 of SiC film is attributable to photon absorption of the SiC film.

From each of the absorption coefficients measured in Fig. 22, a bandgap (Eg) was detected by Tauc Plot shown in the following formula (3).
[Math. 3]

$$\alpha h v^{1/2} = A(h v - Eg) \qquad (3)$$

In the formula, $\alpha$ is an absorption coefficient; h is a Planck's constant; V is a frequency of a photon; and Eg is a bandgap energy.

The power 1/2 on the left side of the formula (3) assumes an indirect transition. When a curve obtained by plotting $(\alpha h v)^{1/2}$ on the Y-axis and the photon energy on the X-axis is extrapolated to the X-axis by linear approximation, an intersection with the X-axis, i.e. an intercept, is detected as Eg.

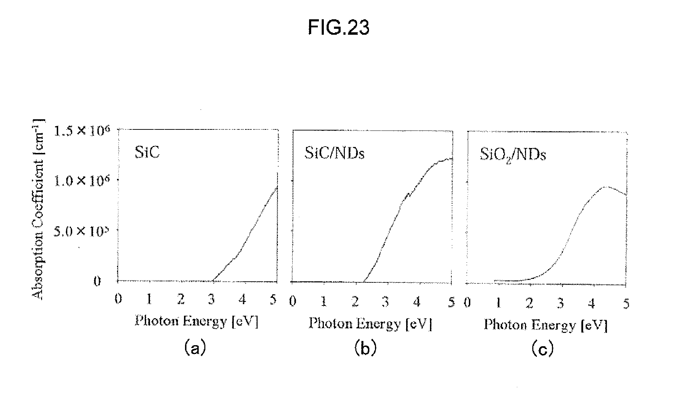

Figs. 23(a) to (c) are graphs showing the Tauc plot, in which Fig. 23 (a) shows the case of a 5 nm-thick SiC film, Fig. 23(b) shows the case of the two-dimensional Si quantum nanodot array 10 of Example having intermediate layer 6 of SiC film, and Fig. 23(c) shows the case of the two-dimensional Si quantum nanodot array 10 of Example having intermediate layer 6 of $SiO_2$ film. In Fig. 23, the horizontal axis indicates the photon energy (eV), and the vertical axis indicates $(\alpha h v)^{1/2}(cm^{-1}eV^{1/2})$. In the two-dimensional Si quantum nanodot array 10 of Example having the intermediate layer 6 of SiC film, each of the thicknesses of the SiC film and Si is 4 nm. In the two-dimensional Si quantum nanodot array 10 of Example having the intermediate layer 6 of $SiO_2$ film, the thickness of the $SiO_2$ film is 3 nm, and the thickness of Si is 4 nm.

Fig. 23(a) shows that Eg of the SiC film having thickness of 5 nm is 3.4 eV. Fig. 23(b) shows that Eg of the two-dimensionally arranged Si quantum nanodot array 10 having the thickness of 4 nm and the intermediate layer 6 of the SiC film having thickness of 4 nm is 2.0 eV. The value is the same as the two-dimensionally arranged Si quantum nanodot array 10 having the intermediate layer 6 of $SiO_2$ film shown in Fig. 23(c).

From the results, it is revealed that the bandgap of the two-dimensionally arranged Si quantum nanodot array 10 having the intermediate layer 6 of SiC film is decided by the structure of the Si quantum nanodot array 10 since the bandgap of Si is smaller than the bandgap of SiC.

In view of the above, it was proved that the absorption coefficient of the two-dimensionally arranged Si quantum nanodot array 10 of Example having the intermediate layer 6 of SiC film can be increased to a value larger than that of the array with the intermediate layer 6 of $SiO_2$ without changing Eg thereof.

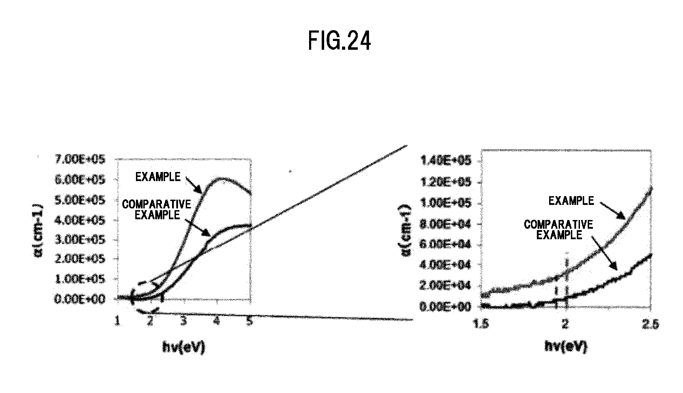

Figs. 24(a) to (b) are graphs for comparing the absorption coefficients of the two-dimensionally arranged quantum nanodot arrays 10 of Example and Comparative Example, in which Fig. 24(a) shows measurement values, and Fig. 24(b) is an enlarged view of the portion enclosed by a dotted circle in Fig. 24(a). In Fig. 24, the horizontal axis indicates a photon energy (eV), and the vertical axis indicates an absorption coefficient ($cm^{-1}$). Listeria ferritin 33 is used in Example, and conventional ferritin is used in Comparative Example.

From Fig. 24, it was proved that the absorption coefficient of Example using Listeria ferritin 33 is increased to a value of about 5 times that of Comparative Example using ferritin.

(Example of Quantum Nanodot Comprising GaAs)

Hereinafter, Example of a two-dimensional quantum nanodot array 1 in which quantum nanodots are formed of GaAs will be described.

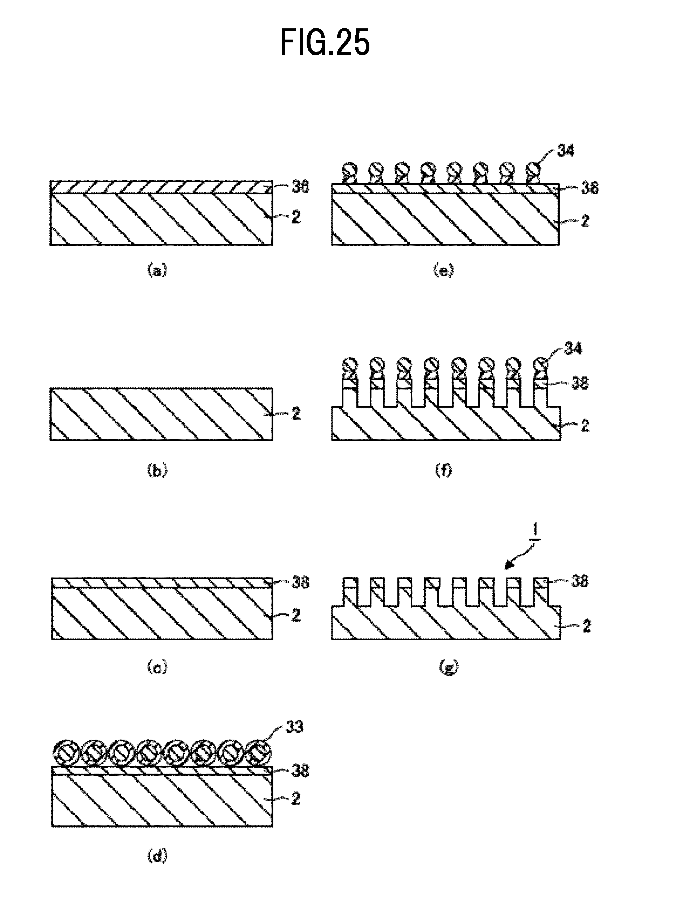

Figs. 25(a) to 25(g) show a method for producing the two-dimensional quantum nanodot array 1 comprising GaAs in the order of process steps.

(a) A GaAs substrate 2 was prepared. A natural oxide film 36 was formed on a surface of the GaAs substrate 2.

(b) The natural oxide film 36 on the GaAs substrate 2 was removed by hydrogen radicals. A flow rate of hydrogen was kept to 40 sccm, and the hydrogen radicals were generated by a high frequency power source of 200 W at 13.56 MHz.

(c) After removing the natural oxide film 36, the GaAs substrate was inserted into an oxidation chamber of the NB apparatus to form an oxide film 38 having a thickness of 1 nm on the GaAs substrate at a room temperature. The oxide film 38 is referred to as GaAs oxide film or NB oxide film. A flow rate of oxygen was 5 sccm, and a pressure was 0.14 Pa. Output of the high frequency power source at 13.56 MHz was 500 W.

(d) A two-dimensional array of Listeria ferritin 33 was deposited on $SiO_2$.

(e) Shells of Listeria ferritin 33 were removed by an oxygen radical treatment. Thus, a state in which two-dimensional arrays 34 formed of iron oxide cores 34a were deposited on the GaAs oxide film was attained. The two-dimensional arrays 34 formed of these iron oxide cores were used as a mask for etching in the following step.

(f) Etching on GaAs was performed by NB.

(g) The iron oxide cores 34a were removed by HCl wet etching.

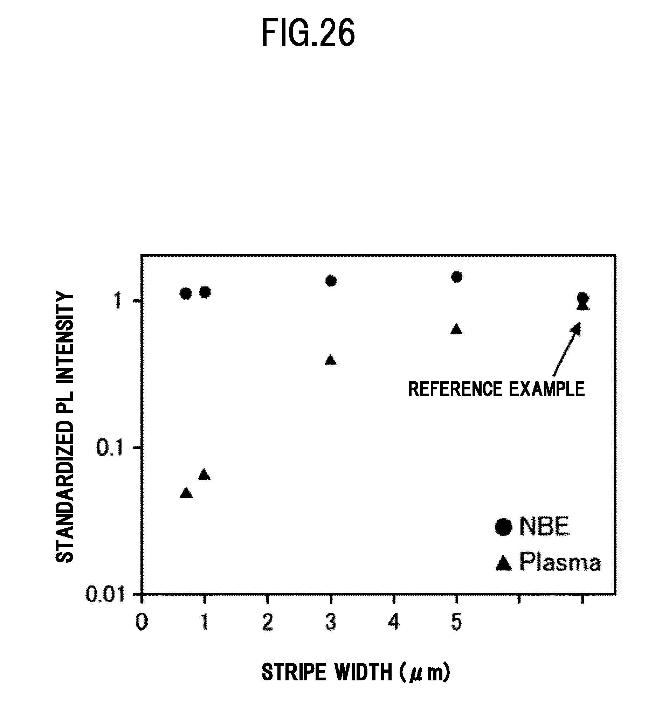

Fig. 26 is a diagram showing PL spectrums of GaAs after NB etching and conventional plasma etching. In the NB etching, stripe patterns of widths of 5, 3, 1, and 0.7 $\mu$m were used. A comparative sample was a GaAs substrate which had no patterning and was not subjected to etching. In Fig. 26, the horizontal axis indicates the stripe width ($\mu$m), and the vertical axis indicates PL spectrum intensity standardized by PL spectrum intensity of the comparative sample. As is apparent from Fig. 26, it was confirmed that, in the case of the NB etching, the PL spectrum intensity of GaAs after etching is almost the same as that before the etching and does not depend on the stripe width.

In contrast to the NB etching, the PL spectrum of GaAs after the conventional plasma etching shows that non-luminescent recoupling is increased due to a breakage caused by a damage and that the PL spectrum intensity is decreased. The degrees of the increase and decrease become more prominent along with the reduction in stripe width (see Non-Patent Literature 11).

From the results, it is revealed that the NB etching has the advantage of not damaging the GaAs surface. Therefore, the NB etching is the suitable as the method for producing the GaAs quantum nanodots 3.

(Arrangement of Listeria Ferritin)

Listeria ferritin 33 is generated from DNA information and includes uniform cores of 7 nm formed of iron oxide ($Fe_2O_3$).

In order to form a monomolecular layer of Listeria ferritin 33 which is uniform, has high in-plane density, and is two-dimensionally arranged, conditions for a surface oxide film are important factors. The mechanism of self-assembly of conventional ferritin has been studied (see Non-Patent Literature 6).

A highly hydrophilic surface is capable of reducing absorption power of Listeria ferritin 33 and of aiding movement of Listeria ferritin 33 in such a manner that a sufficient degree of freedom of the movement is ensured.

On the other hand, a repulsion power due to a negative charge of Listeria ferritin 33 per se is capable of aiding Listeria ferritin 33 in such a manner that multilayer formation caused during the movement is prevented.

Therefore, after a step of spin-coating Listeria ferritin 33, the monomolecular layer of Listeria ferritin 33 having high in-plane density and two-dimensionally arranged is formed by the self-assembly.

The above-described NB oxide film (GaAs-NBO) formed on the GaAs surface by the NB apparatus is highly hydrophilic and has a high zeta potential of -20 mV (Non-Patent Literature 6).

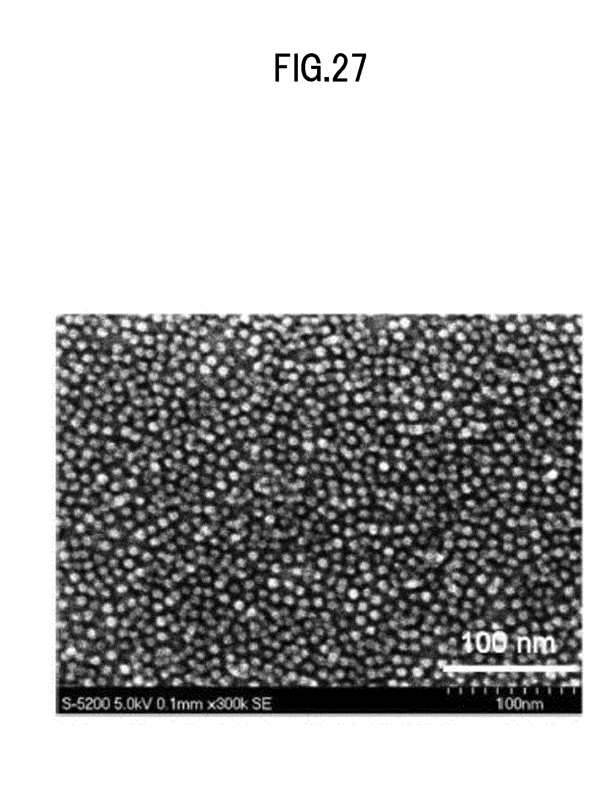

Fig. 27 is a scanning electron microscopic image of a surface of Listeria ferritin 33 which is formed and two-dimensionally arranged on a NB oxide film formed on GaAs. As is apparent from Fig. 27, it is revealed that Listeria ferritin 33 formed on GaAs is free from vacancy.

(Removal of Protein Shells)

Shells of Listeria ferritin were removed by an oxygen radical treatment.

The oxygen radical treatment was performed at a room temperature (RT), 200°C, and 280°C, each for a treatment time of 30 minutes. In order to examine removal of Listeria ferritin 33, presences of C=O bonding and N-H bonding were examined by using a Fourier transform infrared spectroscopy (FTIR) device.

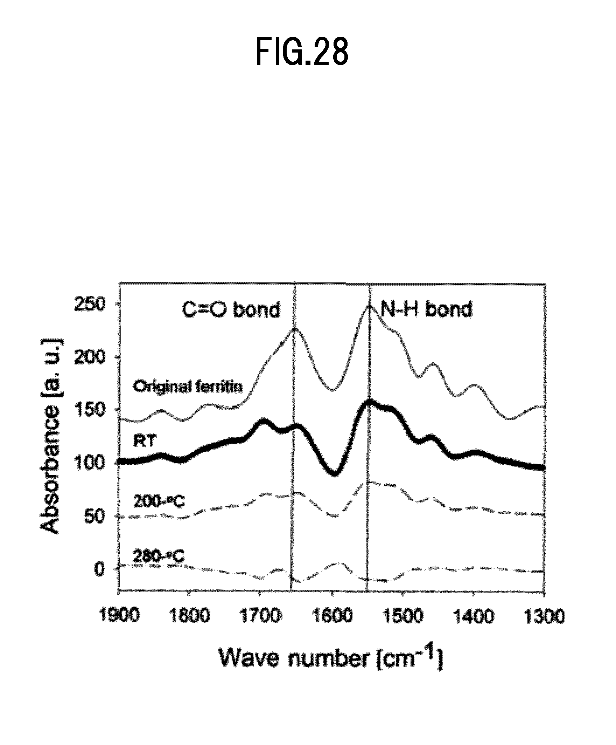

Fig. 28 shows FTIR spectrums measured by Fourier transform infrared spectroscopy of the GaAs surface after the oxygen radical treatment. In Fig. 28, the horizontal axis indicates a wavenumber ($cm^{-1}$), and the vertical axis indicates absorbance (arbitrary scale). For comparison, an FTIR spectrum of Listeria ferritin 33 on which the oxygen radical treatment was not performed is shown together.

As is apparent from Fig. 28, it is revealed that the C=O bonding and the N-H bonding are observed when the oxygen radical treatment temperature is the room temperature and 200°C. When the oxygen radical treatment temperature is raised to 280°C, the C=O bonding and N-H bonding are not observed, which means that the shells of Listeria ferritin 33 are removed. The cores of iron oxide were two-dimensionally arranged in the high-density also in this case.

(NB Etching and Removal of iron Oxide Cores)

GaAs etching was performed under the following conditions.

Etching conditions are:

Etching gas: mixture gas of chlorine ($Cl_2$) and argon (Ar)
Chlorine gas flow rate: 9 sccm
Argon gas flow rate: 31 sccm
Output of 13.56 MHz power source: 800 W
Output of low frequency bias power source: 16, and
Substrate temperature: -16°C.

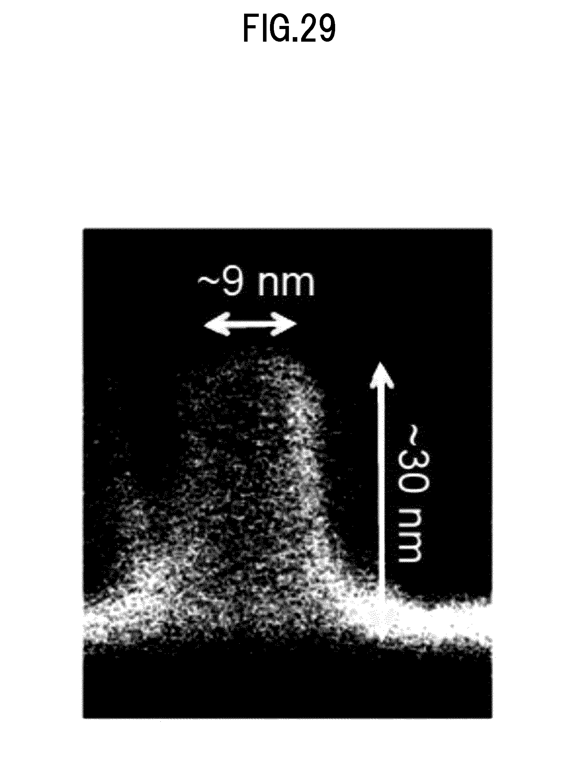

Fig. 29 is scanning electron microscopic image of a cross-section after the NB etching on GaAs. As is apparent from Fig. 29, it is revealed that a column having a high aspect ratio of a diameter of 9 nm and a depth of 30 nm, formed of GaAs, and having nano-order dimensions is formed. Also, a surface of GaAs on the bottom side which was subjected to the NB etching, i.e. an etching surface, is flat, and unevenness of the etching surface is 1 nm.

(Removal of Iron Oxide Cores)

The iron oxide cores were removed by performing wet etching using a diluted hydrochloric acid solution ($HCl:H_2O$ = 1:10) for 10 minutes. The removal of iron oxide cores was confirmed by measurement by X-ray photoelectron spectroscopy (XPS). Thus, the high density two-dimensionally arranged GaAs quantum nanodot array 1 was realized by the step described with reference to Fig. 25, i.e. the top-down production method using the iron oxide cores as a mask.

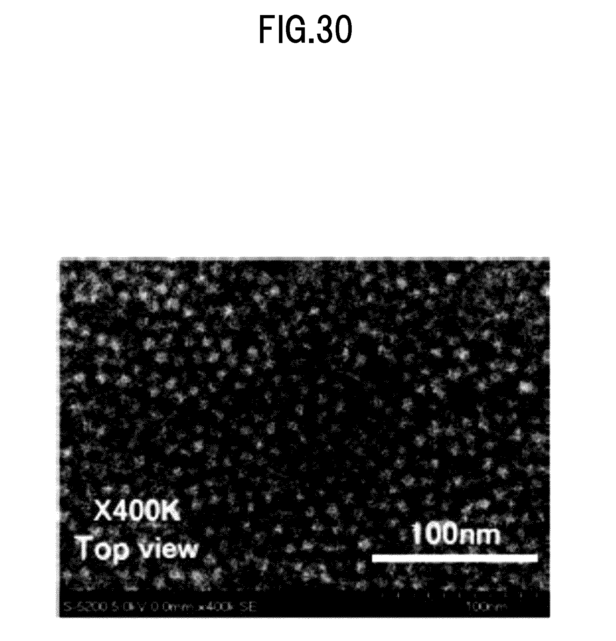

Fig. 30 is a scanning electron microscopic image of a surface of the two-dimensionally arranged GaAs quantum nanodot array 1. The magnification is ×40000. As is apparent from Fig. 30, a diameter is about 7 nm. A thickness of each of the quantum nanodots 3 is about 10 nm, and a surface density of the quantum nanodots 3 is $7 \times 10^{11}/cm^2$.

(Solar Cell Using Si Quantum Nanodot Array)

A solar cell was produced by using an Si quantum nanodot array.

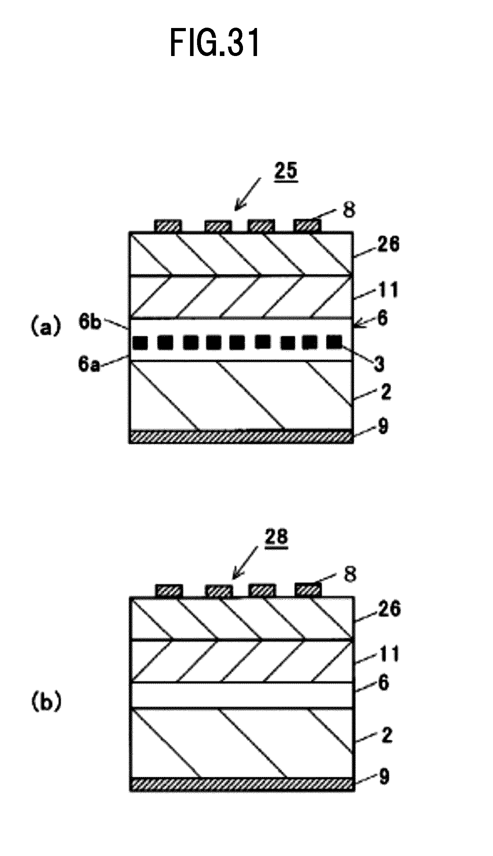

Fig. 31(a) to (b) are sectional views of structures of solar cells 25 and 28, in which Fig. 31(a) shows the case of using the Si quantum nanodots 3, and Fig. 31(b) shows the case of using the SiC layer 6 alone.

As shown in Fig. 31(a), the solar cell 25 using the Si quantum nanodots 3 is provided with a p-layer electrode 9, a substrate 2 comprising p-type Si, the Si quantum nanodot 3, an intermediate layer 6, an n-layer 11 comprising n-type Si, a protection film 26, and an n-layer electrode 8. The Si quantum nanodots 3 are formed between a first intermediate layer 6a and a second intermediate layer 6b. As the intermediate layers 6, SiC or $SiO_2$ is used. Hereinafter, the solar cell 25 using the Si quantum nanodots 3 is described as 2 nm Sic/2 nm SiND/2 nm. As used herein, 2 nm SiC is an SiC layer 6 having a thickness of 2 nm, and 2 nm SiND is the Si quantum nanodot 3 having a thickness of 2 nm.

As shown in Fig. 31(b), the solar cell 28 using a SiC layer 6 is provided with a p-layer electrode 9, a substrate 2 comprising p-type Si, the SiC layer 6, an n-layer 11 comprising n-type Si, a protection film 26, and an n-layer electrode 8. Hereinafter, the solar cell 28 using the SiC layer 6 is described as 2 nm SiC. As used herein, 2 nm is a thickness of the SiC layer 6.

The solar cells 25 and 28 using the SiC layer 6 and the Si quantum nanodots 3 were produced as described below.

Two-dimensional quantum nanodot array 1 was produced by using a 1.0- to 1.5-$\Omega$ p-substrate 2 having a thickness of 400 $\mu$m and employing the method shown in Fig. 12. An uppermost layer was the SiC layer 6. The thus-formed two-dimensional quantum nanodot array 1 had a diameter of about 6.4 nm (see Fig. 14).

An Si layer having a thickness of 30 nm was epitaxially grown on the SiC layer 6 by electron beam evaporation method at 600°C. The grown Si layer was formed into the n-layer 11 doped with impurity of phosphor (P) by a diffusion method with RTA (Rapid Thermal Annealing). The layer was a very thin n+ layer and is called also as an n-emitter layer. An ITO film having a thickness of 70 nm, which serves as the protection film 26, was formed on the n-layer 11. The ITO film 26 is a so-called transparent electrode.

An electrode 9 was formed on the p-substrate 2 by using an aluminum paste. A finger electrode 8 was formed on the ITO film 26 on the surface by using a silver paste.

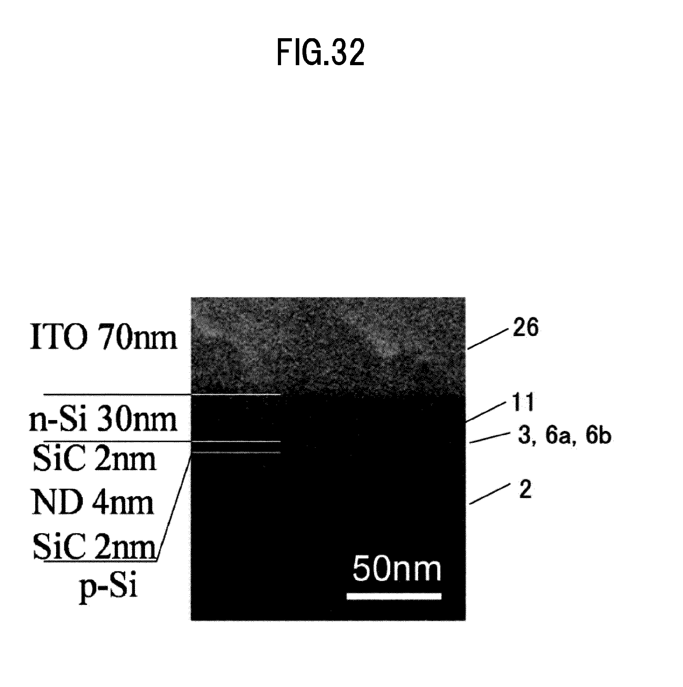

Fig. 32 is a diagram showing a scanning electron microscopic (SEM) image of a cross-section of the solar cell 25 using the produced Si quantum nanodots 3. Fig. 32 shows that the SiC layer 6a having thickness of 2 nm, the Si quantum nanodots 3, the SiC layer 6b having thickness of 2 nm, the n-layer 11 having thickness of 30 nm, and the ITO layer 26 having thickness of 70 nm are formed in this order on the p-type substrate 2.

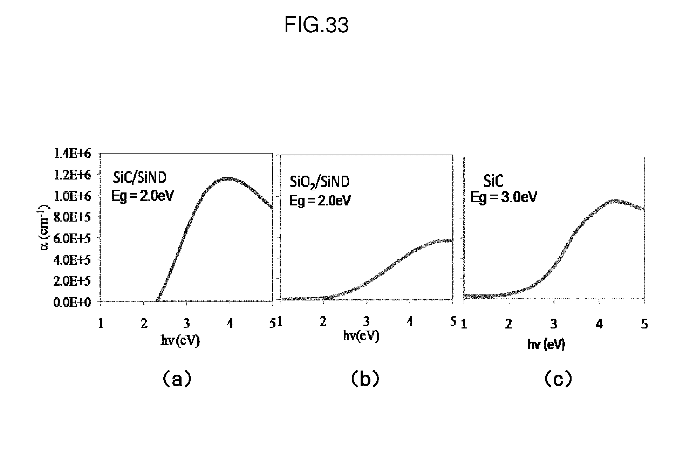

Fig. 33(a) to (c) are graphs showing measurement results of absorption coefficients detected by UV-visible-near infrared spectroscopy; in which Fig. 33(a) shows the case of a film comprising a 3 nm-thick SiC layer 6 and Si quantum nanodots 3, Fig. 33(b) shows the case of a film comprising a 3 nm-thick $SiO_2$ layer 6 and Si quantum nanodots 3, and Fig. 33(c) shows the case of a film comprising a 5 nm-thick SiC layer 6 alone.

Fig. 33 shows that the light absorption at 2 to 3 eV of the film formed of the SiC layer 6 having thickness of 3 nm and the Si quantum nanodots 3 is considerably increased as compared to the film formed of the $SiO_2$ layer 6 as the intermediate layer and the Si quantum nanodots 3 and the film using the SiC layer 6 alone.

Hereinafter, an IV property of the produced two-dimensionally arranged quantum nanodots 3 having the intermediate layer 6 will be described. The IV property was measured by using the conductive atomic force microscope (AFM) described in Fig. 21.

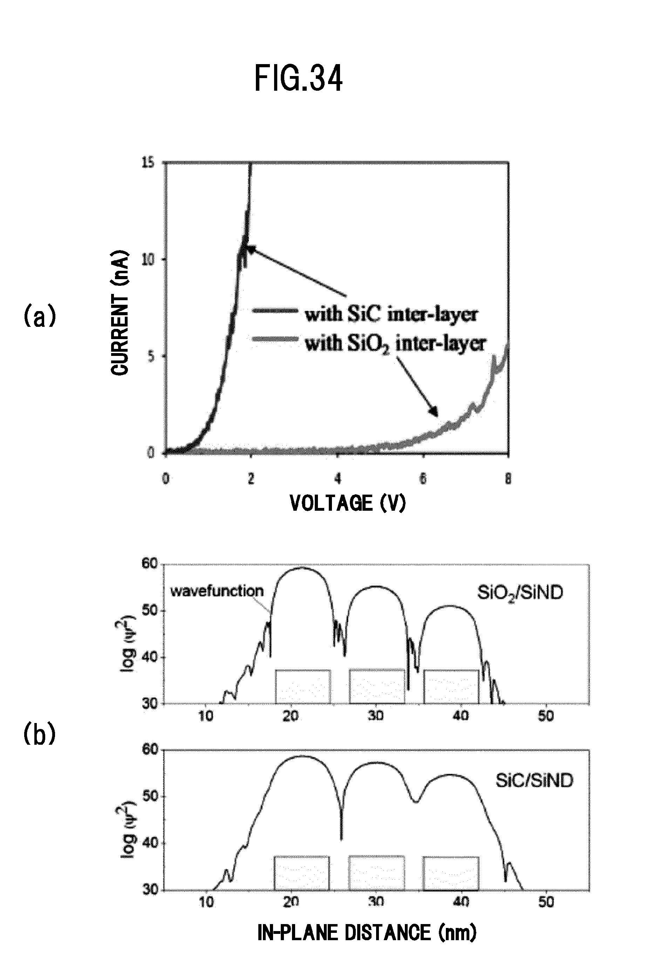

Fig. 34(a) to (b) are diagrams on the two-dimensional quantum nanodots 3 having the intermediate layer 6, in which Fig. 34(a) shows an IV property and Fig. 34(b) shows space probability of electrons.

Fig. 34(a) shows that a larger current and a lower threshold voltage are obtained in the case where the intermediate layer 6 is formed of SiC as compared to the case where the intermediate layer 6 is formed of SiO$_2$. This is because the coupling of wavefunctions of the Si quantum nanodots 3 is strengthened to form a wide intermediate band in the case where the intermediate layer 6 is formed of SiC.

Fig. 34(b) is the diagram showing space probability of electrons which was detected by calculating Schrödinger equation in the intermediate layer 6 and the three adjacent quantum nanodots 3 by the classic envelope function theory. In the diagram, the horizontal axis indicates a spacing in the quantum nanodot array, and the vertical axis indicates the space probability of electrons of logarithmic scale.

Fig. 34(b) shows that the coupling of wavefunctions is strengthened when the intermediate layer 6 is formed of SiC as compared to the case where the intermediate layer 6 is formed of SiO$_2$. The phenomenon is attributable to the fact that an energy of a barrier at an interface between the SiC layer 6 and the Si nanodots 3 is lower than that between the SiO$_2$ layer 6 and the Si nanodots 3. In other words, since the wavefunctions are readily diffused over the barrier at the interface between the SiC layer 6 and the Si nanodots 3, they are readily coupled with each other. Thus, since the coupling of wavefunctions is stronger in the case of the Si quantum nanodots 3 using SiC as the intermediate layer 6 as compared to the case where the intermediate layer 6 is the SiO$_2$ layer, light absorption and carrier mobility are enhanced.

(Light Absorption Property of Solar Cell)

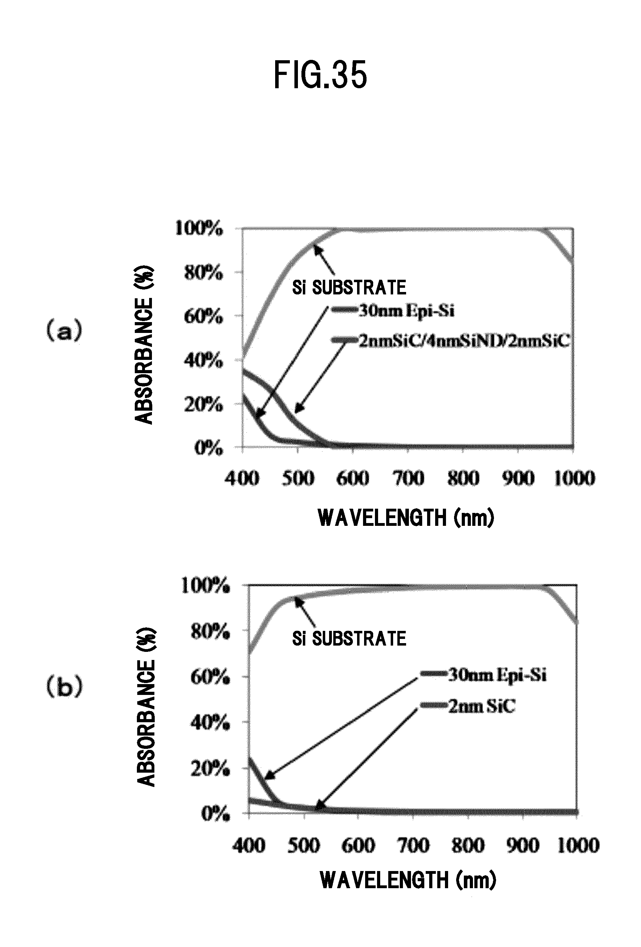

Figs. 35(a) to (b) are graphs showing measurement results of light absorption coefficients of the solar cells 25 and 28, in which Fig. 35(a) shows the case of the solar cell 25 having the 2 nm-thick SiC layer 6 and the 4 nm-thick Si quantum nanodots 3, and Fig. 35(b) shows the case of the solar cell 28 having the 2 nm-thick SiC layer 6.

Fig. 35 shows that the solar cell 25 having the 2 nm-thick SiC layer 6 and the 4 nm-thick Si quantum nanodots 3 has the much better light absorption property than the solar cell 28 having the 2 nm-thick SiC layer 6.

(Properties of Solar Cell)

Properties of the solar cells 25 and 28 were evaluated by using an evaluation device (YQ-250BX; product of JASCO) using an AM 1.5 solar simulator (100 mW/cm$^2$, 298 K) as a light source.

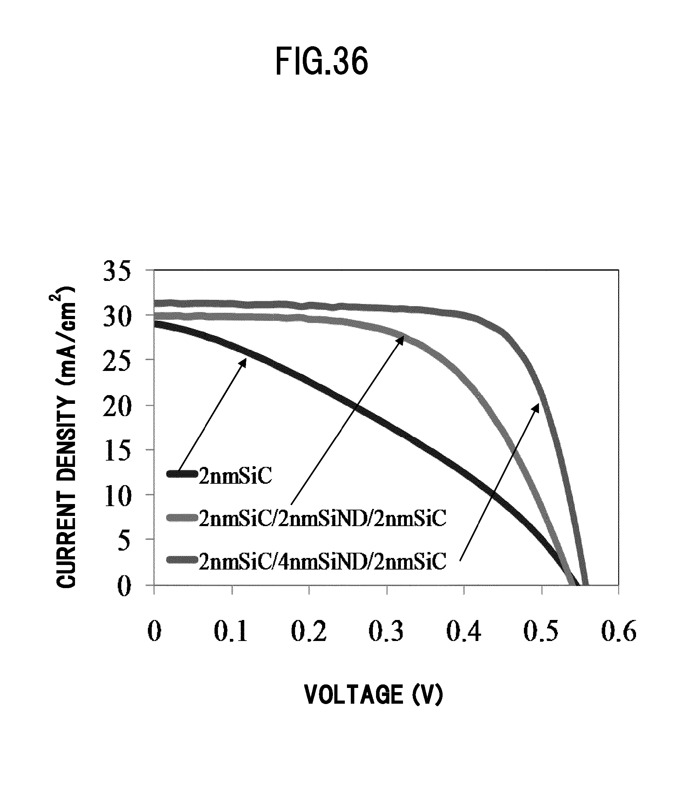

Fig. 36 is a diagram showing IV properties of the solar cells 25 and 28. In Fig. 36, the horizontal axis indicates a voltage (V) generated in the solar cell, and the vertical axis indicates a density of current flowing through the solar cell (mA/cm$^2$).

Fig. 36 shows that the solar cell 25 having the SiC layer 6 and the Si quantum nanodots 3 is capable of obtaining the larger current density than the solar cell 28 having the SiC layer 6 having thickness of 2 nm.

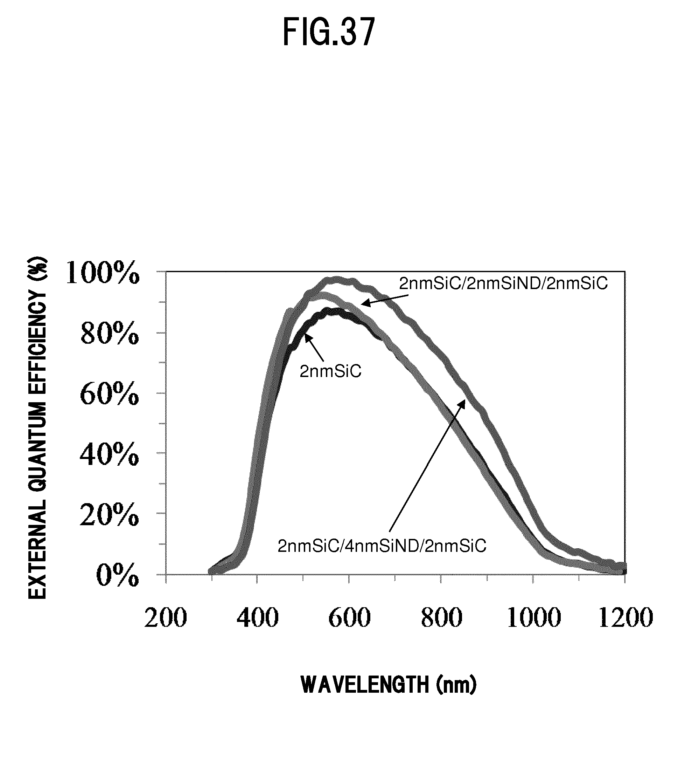

Fig. 37 is a diagram showing a relationship between a wavelength and external quantum efficiency of each of the solar cells 25 and 28. In Fig. 37, the horizontal axis indicates the wavelength (nm), and the vertical axis indicates the external quantum efficiency (%) of the solar cells.

Fig. 37 shows that the solar cell 25 having the SiC layer 6 and the Si quantum nanodots 3 obtains the peak of the external quantum efficiency at about 620 nm and that the solar cell 28 having the SiC layer 6 having thickness of 2 nm shifts the peak of the external quantum efficiency to the short wavelength side, i.e. causes the blue shift.

Table 1 shows short-circuit current density J$_{sc}$ (mA/cm$^2$), an open voltage V$_{oc}$ (V), a curve factor (also referred to as Fill Factor or FF), and efficiency (%) of each of the solar cells together.

The curve factor (FF) is represented by the following formula (4).

[Math. 4]

$$FF = \frac{V_{\max} \times I_{\max}}{V_{oc} \times I_{sc}} \qquad (4)$$

As used herein, V$_{max}$ and I$_{max}$ are a voltage and a current at the maximum output point of the solar cell, and I$_{sc}$ is a short-circuit current. The efficiency of the solar cell is increased proportionally to V$_{oc}$, I$_{sc}$, and the curve factor.

[Table 1]

| Solar Cell Structure | Jsc (mA/cm$^2$) | Voc (mA/cm$^2$) | Curve Factor (FF) (%) | Efficiency (%) |
|---|---|---|---|---|
| 2 nm SiC | 29.0 | 0.544 | 34 | 5.4 |
| 2 nm SiC/2 nm SiND/2 nm SiC | 29.9 | 0.539 | 58 | 9.3 |

(continued)

| Solar Cell Structure | Jsc (mA/cm$^2$) | Voc (mA/cm$^2$) | Curve Factor (FF) (%) | Efficiency (%) |
|---|---|---|---|---|
| 2 nm SiC/4 nm SiND/2 nm SiC | 31.3 | 0.556 | 72 | 12.6 |

As shown in Table 1, the solar cell 25 having the SiC layer 6 having thickness of 2 nm and the Si quantum nanodots 3 having thickness of 2 nm attained the short-circuit current density of 29.9 mA/cm$^2$, the open voltage of 0.539 V, the curve factor of 58%, and the efficiency of 9.3%.

The solar cell 25 having the SiC having thickness of 2 nm and the SiND having thickness of 4 nm attained the short-circuit current density of 31.3 mA/cm$^2$, the open voltage of 0.556 V, the curve factor of 72%, and the efficiency of 12.6%.

The solar cell 28 having the SiC layer 6 having thickens of 2 nm attained the short-circuit current density of 29.0 mA/cm$^2$, the open voltage of 0.544 V, the curve factor of 34%, and its efficiency of 5.4%.

From the above results, the solar cell 25 having the SiC layer 6 having thickens of 2 nm and the Si quantum nanodots 3 having thickness of 4 nm attains the excellent results that all of the short-circuit current density, the open voltage, the curve factor, and the efficiency are large. The monolayer structure two-dimensional quantum nanodot array having the quantum nanodots 3 and the intermediate layer 6 was used in the solar cell 25, and the efficiency of the solar cell can be further improved by using a multilayer structure two-dimensional quantum nanodot array including about 5 layers.

The present invention is not limited to the above-described embodiments, and various modifications can be implemented within the scope of the present invention recited in claims. The modifications are of course encompassed by the scope of the present invention.

**Claims**

1. A quantum nanodot comprising a semiconductor and having an outer diameter in two-dimensional directions which is not more than twice a bore radius of an exciton in the semiconductor.

2. The quantum nanodot according to claim 1, wherein the semiconductor is Si, and the outer diameter in two-dimensional directions is 10 nm or less.

3. The quantum nanodot according to claim 2, wherein luminescence is produced.

4. The quantum nanodot according to claim 2 or 3, wherein
a half width value of a luminescence peak at 665 nm of the quantum nanodot is about 0.2 eV in photoluminescence properties excited at 400 nm.

5. The quantum nanodot according to any one of claims 1 to 4, wherein the quantum nanodot can control a quantum confinement effect by changing a thickness and a dimension in two-dimensional directions.

6. The quantum nanodot according to any one of claims 2 to 5, wherein a surface density of the quantum nanodot is $1\times10^{12}$/cm$^2$ to $5\times10^{12}$/cm$^2$.

7. A two-dimensional quantum nanodot array, wherein
quantum nanodots comprising a semiconductor and each having an outer diameter in two-dimensional directions which is not more than twice a bore radius of an exciton in the semiconductor are two-dimensionally and uniformly arranged; and
a spacing between the quantum nanodots is 1 to 10 nm.

8. The two-dimensional quantum nanodot array according to claim 7, wherein the semiconductor is Si, and the outer diameter in two-dimensional directions is 10 nm or less.

9. The two-dimensional quantum nanodot array according to claim 8, wherein luminescence is produced.

10. The two-dimensional quantum nanodot array according to claim 8 or 9, wherein a half width value of a luminescence peak at 665 nm of the quantum nanodots is about 0.2 eV in photoluminescence properties excited at 400 nm.

**11.** The two-dimensional quantum nanodot array according to claim 10, wherein a surface density of the quantum nanodot is $1 \times 10^{12}/cm^2$ to $5 \times 10^{12}/cm^2$.

**12.** The two-dimensional quantum nanodot array according to claim 10, further comprising an intermediate layer comprising a semiconductor or an insulator which is filled in a space between the quantum nanodot arrays.

**13.** The two-dimensional quantum nanodot array according to any one of claims 7 to 12, wherein a transport property of the two-dimensional quantum nanodot array is controlled by a distance between the adjacent quantum nanodots.

**14.** The two-dimensional quantum nanodot array according to any one of claims 7 to 13, wherein an optical absorption property and a carrier transport property of the two-dimensional quantum nanodot array are controlled by a distance between the adjacent quantum nanodots.

**15.** The two-dimensional quantum nanodot array according to claim 12, wherein the intermediate layer comprises a semiconductor or an insulator having a bandgap which is larger than that of the quantum nanodot.

**16.** The two-dimensional quantum nanodot array according to claim 15, wherein the intermediate layer is any one of $SiO_2$, $Si_3O_4$, and SiC.

**17.** The two-dimensional quantum nanodot array according to claim 15, wherein a transport property of the two-dimensional quantum nanodot array is controlled by the intermediate layer and a distance between the adjacent quantum nanodots.

**18.** The two-dimensional quantum nanodot array according to claim 15, wherein an optical absorption property of the two-dimensional quantum nanodot array is controlled by the intermediate layer and a distance between the adjacent quantum nanodots.

**19.** A semiconductor device comprising the two-dimensional quantum nanodot array defined in any one of claims 7 to 18.

**20.** The semiconductor device according to claim 19, wherein the semiconductor device is a solar cell.

**21.** The semiconductor device according to claim 20, wherein the solar cell comprises the two-dimensional quantum nanodot array at least and two or more layers having different bandgap energies.

**22.** The semiconductor device according to claim 19, wherein the solar cell has a structure that a plurality of two-dimensional quantum nanodot arrays having an identical bandgap are laminated.

**23.** The semiconductor device according to claim 19, wherein the semiconductor device is a semiconductor laser, and an active layer of the semiconductor laser comprises the two-dimensional quantum nanodot array.

**24.** A method for producing two-dimensional quantum nanodot array, comprising the steps of:

forming a protein containing a metal having an outer diameter in two-dimensional directions which is not more than twice a bore radius of an exciton in a semiconductor on a semiconductor layer which is to be formed into quantum nanodots in two-dimensional directions;
etching the protein;
forming two-dimensionally arranged quantum nanodots which comprise the semiconductor layer by etching the semiconductor layer by using a compound which contains the metal exposed by the etching as a mask; and
etching the metal-containing compound.

**25.** The method for producing two-dimensional quantum nanodot array according to claim 24, wherein the metal-containing protein is Listeria ferritin.

**26.** The method for producing two-dimensional quantum nanodot array according to claim 24, wherein the semiconductor layer is deposited by using neutral particles.

**27.** The method for producing two-dimensional quantum nanodot array according to claim 24, wherein the semiconductor layer is subjected to etching using neutral particles.

28. The method for producing two-dimensional quantum nanodot array according to any one of claims 24 to 27, wherein a layer to be used as an intermediate layer is deposited on the two-dimensional quantum nanodots formed after performing the etching on the metal-containing compound.

# FIG.1

(a)

(b)

# FIG.2

BORE RADIUS × 2

# FIG.3

# FIG.4

# FIG.5

(a)

(b)

# FIG.6

# FIG.7

(a)

SiC

0.5eV

c-Si

1.1eV

0.9eV

10

(b)

Si$_3$N$_4$

1.9eV

c-Si

1.1eV

2.3eV

10

(c)

SiO$_2$

3.2eV

c-Si

1.1eV

4.7eV

10

# FIG.8

(a)

(b)

CHANGE DEPENDING ON
INTERMEDIATE LAYER MATERIAL OR S

# FIG.9

LIGHT ABSORPTION PROPERTY

$\alpha\ (cm^{-1})$

PRESENT INVENTION

CONVENTIONAL EXAMPLE

$h\nu(eV)$

# FIG.10

# FIG.11

# FIG.12

(a)

(b)

(c)

(d)

(e)

(f)

(g)

(h)

# FIG.13

RARE GAS

# FIG.14

(a)

(b)

# FIG.15

SEM IMAGE

50nm

# FIG.16

(a)

(b)

(c)

# FIG.17

(a)                                                (b)

# FIG.18

# FIG.19

# FIG.20

# FIG.21

FIG.22

FIG.23

(a)          (b)          (c)

FIG.24

# FIG.25

(a)

(b)

(c)

(d)

(e)

(f)

(g)

# FIG.26

# FIG.27

# FIG.28

# FIG.29

# FIG.30

# FIG.31

(a)

(b)

# FIG.32

ITO 70nm        26

n-Si 30nm      11

SiC 2nm      3, 6a, 6b

ND 4nm

SiC 2nm      2

p-Si

50nm

FIG.33

(a)

(b)

(c)

# FIG.34

(a)

(b)

# FIG.35

(a)

(b)

# FIG.36

FIG.37

## INTERNATIONAL SEARCH REPORT

| | International application No. |
|---|---|
| | PCT/JP2012/065172 |

A. CLASSIFICATION OF SUBJECT MATTER
*H01L31/04*(2006.01)i, *H01S5/343*(2006.01)i, *B82Y20/00*(2011.01)i

According to International Patent Classification (IPC) or to both national classification and IPC

B. FIELDS SEARCHED

Minimum documentation searched (classification system followed by classification symbols)
H01L31/04-H01L31/078, H01S5/00-5/50, B82Y20/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | Conibeer et al., "Silicon quantum dot nanostructures for tandem photovoltaic cells", Thin Solid Films, 2008, 516, 6748-6756 | 1-23 |
| A | WO 2010/137297 A1 (Hitachi, Ltd.), 02 December 2010 (02.12.2010), paragraph [0023]; claims 19, 20, 24 & JP 2010-269435 A | 4,10,23 |
| X | JP 2005-200425 A (Matsushita Electric Industrial Co., Ltd.), 28 July 2005 (28.07.2005), paragraphs [0072], [0136] to [0145]; fig. 7 & JP 2003-33191 A & US 2003/0124741 A1 & US 2006/0024790 A1 & EP 1262489 A1 & KR 10-2002-0087871 A & CN 1388134 A | 1-28 |

☒ Further documents are listed in the continuation of Box C. ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 11 September, 2012 (11.09.12) | 25 September, 2012 (25.09.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| | International application No. |
|---|---|
| | PCT/JP2012/065172 |

C (Continuation).    DOCUMENTS CONSIDERED TO BE RELEVANT

| Category* | Citation of document, with indication, where appropriate, of the relevant passages | Relevant to claim No. |
|---|---|---|
| X | JP 2002-223016 A  (Matsushita Electric Industrial Co., Ltd.), 09 August 2002 (09.08.2002), claim 12; paragraphs [0058] to [0071] (Family: none) | 1-28 |
| X | Seiji SAMUKAWA, "Bio Template Kyokugen Kako ni yoru Ryoshi Kozo no Jitsugen", Dai 55 Kai Extended Abstracts, Japan Society of Applied Physics and Related Societies, 27 March 2008 (27.03.2008), separate vol.0, page 112 | 1-28 |
| X | Tomohiro KUBOTA et al., "Ferritin Core o Mochiita Nano Kozo no Sakusei (4) -Ryoshi Dot Kozo no Sakusei-", Dai 52 Kai Extended Abstracts, Japan Society of Applied Physics and Related Societies, 29 March 2005 (29.03. 2005), separate vol.3, page 1514 | 1-28 |
| X | Seiji SAMUKAWA, Bio-nano Process and Ultimate Top-down Etching, Proceedings of The Fourth International Symposiumu on Advanced Fluid Information and The First Internatioal Symposium on Transdisciplinary Fluid Integration, 2006.10.02 (received date), Vol. 4th, pages 63 to 65 | 1-28 |
| X | Gen Yamazaki et al, Nano-etching Using Nanodots Mask Fabricated by Bio-nano-process, Journal of Photopolymer Science and Technology, 2003.07.15 (received date), Vol.16 No.3, pages 439 to 444 | 1-28 |
| A | JP 2009-290025 A  (Tohoku University), 10 December 2009 (10.12.2009), entire text; all drawings (Family: none) | 26 |
| A | JP 2009-290026 A  (Tohoku University), 10 December 2009 (10.12.2009), entire text; all drawings (Family: none) | 27 |
| A | JP 2006-49817 A  (Showa Denko Kabushiki Kaisha), 16 February 2006 (16.02.2006), entire text; all drawings & US 2008/0085604 A1    & WO 2006/004224 A1 & CN 1981367 A | 27 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009290026 A

### Non-patent literature cited in the description

- **G. CONIBEER.** *Thin Solid Films,* 2009, vol. 511, 654
- **Y. OKADA ; R. OSHIMA ; A. TAKATA.** *J. Appl. Phys.,* 2009, vol. 106, 024306
- **R. B. LAGHUMAVARAPU ; M. EL-EMAWY ; N. NUNTAWONG ; A. MOSCHO ; L. F. LESTER ; D. L. HUFFAKER.** *Appl. Phys. Lett.,* 2007, vol. 91, 243115
- **R. P. RAFFAELLE ; S. L. CASTRO ; A. F. HEPP ; S. G. BAILEY.** *Prog., Photovolt., Res. Appl.,* 2002, vol. 10, 443
- **C. H. HUANG ; X. Y. WANG ; M. IGARASHI ; A. MURAYAMA ; Y. OKADA ; I. YAMASHITA ; S. SAMUKAWA.** *Nanotechnology,* 2011, vol. 22, 105301
- **M. IGARASHI et al.** Direct fabrication of uniform and high density of sub-10 nm etching mask using ferritin molecules on Si and GaAs surface for actual quantum-dot superlattice. *Appl. Phys. Express,* 2011, vol. 4, 015202
- Superlattice Heterostructure Device. Kogyo Chosakai Publishing Co., Ltd, 10 September 1988, 72
- **W. XIAOMING ; L. V. DAO ; P. HANNAFORD.** *J. Phys. D: Appl. Phys.,* 2007, vol. 40, 3573
- **W. DE BOER ; H. ZHANG ; T. GREGORKIEWICZ.** *Mater. Sci. Eng.,* 2009, vol. B190, 159
- **K. KUSOVA ; O. CIBULKA ; K. DOHNALOVA ; I. PELANT ; J. VALENTA ; A. FUCIKOVA ; K. ZIDEK ; J. LANG ; J. ENGLICH ; P. MATEJKA.** *ACS Nano,* 2010, vol. 4, 4495
- **T. YOSHIKAWA et al.** Dry etching and consequent burring regrowth of nanosize quantum wells stripes using an in situ ultrahigh vacuum multichamber system. *J. Vac. Sci. Technol. B,* 1998, vol. 16, 1-8